# EUROPÄISCHE PATENTSCHRIFT

(11) **EP 4 143 973 B1**
(45) Veröffentlichungstag und Bekanntmachung des Hinweises auf die Patenterteilung: **11.06.2025**
(21) Anmeldenummer: 21721491.5
(22) Anmeldetag: 23.04.2021
(51) Int. Cl.: H03K 17/96, B60S 1/08, G01N 27/22

(54) **REGENERKENNUNGSVORRICHTUNG, GARTENGERÄT MIT DER REGENERKENNUNGSVORRICHTUNG UND VERFAHREN ZU EINER ERFASSUNG VON REGENTROPFEN AUF EINER OBERFLÄCHE MITTELS EINER REGENERKENNUNGSVORRICHTUNG**
RAIN DETECTION DEVICE, GARDEN APPLIANCE HAVING THE RAIN DETECTION DEVICE, AND METHOD FOR SENSING RAIN DROPS ON A SURFACE BY MEANS OF A RAIN DETECTION DEVICE
DISPOSITIF DE DÉTECTION DE PLUIE, APPAREIL DE JARDIN DOTÉ DU DISPOSITIF DE DÉTECTION DE PLUIE ET PROCÉDÉ DE DÉTECTION DE GOUTTES DE PLUIE SUR UNE SURFACE AU MOYEN D'UN DISPOSITIF DE DÉTECTION DE PLUIE

(30) Priorität: 29.04.2020 DE 102020205401
(43) Veröffentlichungstag der Anmeldung: 08.03.2023
(73) Patentinhaber: Robert Bosch GmbH, 70442 Stuttgart (DE)
(72) Erfinder: ABBOTT, Paul, Swaffham Prior CB25 0JZ (GB); WILD, Chris, Sheffield S10 4BA (GB)
(86) Internationale Anmeldenummer: PCT/EP2021/060673
(87) Internationale Veröffentlichungsnummer: WO 2021/219507

(56) Entgegenhaltungen:
- EP-A1- 0 333 564
- EP-A1- 0 753 438
- EP-A1- 1 686 026
- WO-A1-2020/020652
- US-A1- 2017 277 301

## Beschreibung

### Stand der Technik

Es ist bereits eine Regenerkennungsvorrichtung zu einer Erfassung von Regentropfen auf einer Oberfläche, mit zumindest einer Sensoreinheit, die zumindest ein kapazitives Sensorelement umfasst, wobei das Sensorelement derart ausgebildet und/oder angeordnet ist, dass sich eine Kapazitätskenngröße des Sensorelements in Abhängigkeit von einer Kontaktierung der Oberfläche mittels eines Objekts ändert, und mit zumindest einer Auswerteeinheit, die dazu eingerichtet ist, in Abhängigkeit von einem differentiellen Signal des Sensorelements Regentropfen auf der Oberfläche zu erkennen, vorgeschlagen worden. Beispielsweise sei auf die Druckschriften EP 1 686 026 A1 und EP 0 753 438 A1 verwiesen.

### Offenbarung der Erfindung

Die Erfindung geht aus von einer Regenerkennungsvorrichtung zu einer Erfassung von Regentropfen auf einer Oberfläche, mit zumindest einer Sensoreinheit, die zumindest ein kapazitives Sensorelement umfasst, wobei das Sensorelement derart ausgebildet und/oder angeordnet ist, dass sich eine Kapazitätskenngröße des Sensorelements in Abhängigkeit von einer Kontaktierung der Oberfläche mittels eines Objekts ändert, und mit zumindest einer Auswerteeinheit, die dazu eingerichtet ist, in Abhängigkeit von einem differentiellen Signal des Sensorelements Regentropfen auf der Oberfläche zu erkennen.

Es wird vorgeschlagen, dass die Auswerteeinheit dazu eingerichtet ist, in Abhängigkeit von einer Symmetriekenngröße des differentiellen Signals, insbesondere gegenüber einem Nullpunkt, einen Regentropfen auf der Oberfläche zu erkennen. Unter "eingerichtet" soll insbesondere speziell programmiert, speziell ausgelegt und/oder speziell ausgestattet verstanden werden. Darunter, dass ein Objekt, insbesondere die Auswerteeinheit, zu einer bestimmten Funktion, insbesondere Regentropfen auf der Oberfläche zu erkennen, eingerichtet ist, soll insbesondere verstanden werden, dass das Objekt diese bestimmte Funktion in zumindest einem Anwendungs- und/oder Betriebszustand erfüllt und/oder ausführt. Vorzugsweise ist die Auswerteeinheit als eine Elektronikeinheit, insbesondere als eine bestückte Elektronikplatine, ausgebildet. Vorzugsweise umfasst die Auswerteeinheit zumindest einen Mikrocontroller zu einer Auswertung von über die Sensoreinheit, insbesondere das Sensorelement, erfassten Signalen. Bevorzugt ist die Auswerteeinheit, insbesondere der Mikrocontroller, elektrisch und/oder elektronisch mit der Sensoreinheit, insbesondere dem Sensorelement, verbunden. Vorzugsweise ist die Auswerteeinheit, insbesondere der Mikrocontroller, dazu eingerichtet, zur Erkennung von Regentropfen auf der Oberfläche die über die Sensoreinheit, insbesondere das Sensorelement, erfassten Signale, insbesondere die Kapazitätskenngröße und/oder das differentielle Signal, zumindest im Wesentlichen kontinuierlich auszulesen und insbesondere auszuwerten. Alternativ oder zusätzlich ist denkbar, dass die Auswerteeinheit, insbesondere zur Erkennung von Regentropfen und/oder zu einer Ausführung des Algorithmus, zumindest einen Prozessor und/oder einen FPGA umfasst. Besonders bevorzugt ist die Auswerteeinheit, insbesondere der Mikrocontroller, dazu eingerichtet, das differentielle Signal des Sensorelements in Abhängigkeit von der, insbesondere von dem Sensorelement an die Auswerteeinheit übertragenen, Kapazitätskenngröße zu generieren. Vorzugsweise ist die Auswerteeinheit dazu eingerichtet, zu einer Generierung des differentiellen Signals, insbesondere einer Berechnung eines Werts des differentiellen Signals, jeweils, insbesondere kontinuierlich, zumindest einen Wert der Kapazitätskenngröße mit einem zuvor erfassten anderen Wert der Kapazitätskenngröße zu subtrahieren, wobei insbesondere ein Wert des differentiellen Signals ermittelt wird. Es ist denkbar, dass die Auswerteeinheit dazu eingerichtet ist, das differentielle Signal, insbesondere die Werte des differentiellen Signals, schalttechnisch oder elektronisch, insbesondere mittels des Mikrocontrollers, zu generieren, zu ermitteln und/oder zu berechnen. Es ist auch denkbar, dass die Sensoreinheit dazu vorgesehen ist, das differentielle Signal zu generieren und an die Auswerteeinheit zu übertragen. Unter "vorgesehen" soll insbesondere speziell ausgelegt und/oder ausgestattet verstanden werden. Darunter, dass ein Objekt, insbesondere das Sensorelement, zu einer bestimmten Funktion, insbesondere einer Generierung des differentiellen Signals und/oder einer Übertragung des differentiellen Signals an die Auswerteeinheit, vorgesehen ist, soll insbesondere verstanden werden, dass das Objekt diese bestimmte Funktion in zumindest einem Anwendungs- und/oder Betriebszustand erfüllt und/oder ausführt. Beispielsweise ist das Sensorelement dazu vorgesehen, das differentielle Signal in Abhängigkeit von der Kapazitätskenngröße schalttechnisch zu generieren. Unter einer "Symmetriekenngröße" soll erfindungsgemäß eine Kenngröße eines Signals, insbesondere des differentiellen Signals, verstanden werden, welche eine Symmetrie einer Signalform und/oder über einen Signalverlauf getrennter Wertemengen des Signals beschreibt, insbesondere hinsichtlich eines Nullpunkts des Signals. Erfindungsgemäß ist das differentielle Signal als ein zeitlicher Verlauf einer Änderungsrate der Kapazitätskenngröße des Sensorelements ausgebildet. Unter einer "Kapazitätskenngröße" soll insbesondere eine Kenngröße verstanden werden, die eine elektrische Kapazität, insbesondere als physikalische Größe, eines Systems und/oder eines Bauteils, insbesondere des Sensorelements, beschreibt, beeinflusst und/oder angibt. Insbesondere ist die Sensoreinheit, insbesondere das Sensorelement, derart ausgebildet, dass, falls, insbesondere über Regentropfen, Wasser an der Oberfläche angeordnet wird, sich ein Wert der Kapazitätskenngröße gegenüber einer von Luft umgebenen Oberfläche vergrößert.

Unter einem "kapazitiven Sensorelement" soll insbesondere ein Sensorelement verstanden werden, welches auf Basis einer Veränderung einer elektrischen Kapazität eines einzelnen Kondensators, kondensatorähnlichen oder als Kondensator wirkenden Bauteils oder eines Kondensatorsystems arbeitet. Vorzugsweise ist das kapazitive Sensorelement durch zumindest ein Elektrodenpaar gebildet. Insbesondere ist die Kapazitätskenngröße als die elektrische Kapazität zwischen dem Elektrodenpaar ausgebildet. Insbesondere umfasst die Regenerkennungsvorrichtung genau ein kapazitives Sensorelement, welches insbesondere zumindest ein, vorzugsweise genau ein, Elektrodenpaar ausbildet. Bevorzugterweise ist die Oberfläche beabstandet von dem Elektrodenpaar des Sensorelements angeordnet. Insbesondere ist die Oberfläche als eine Außenfläche der Sensoreinheit, insbesondere eines Isolierelements der Sensoreinheit, ausgebildet und/oder in einem Nahbereich des Sensorelements, insbesondere des Elektrodenpaars, angeordnet. Unter einem "Nahbereich" eines Objekts, insbesondere des Sensorelements und/oder des Elektrodenpaars, soll insbesondere ein Bereich verstanden werden, welcher sich in einem maximalen Abstand von höchstens 3 cm, vorzugsweise höchstens 2 cm und bevorzugt höchstens 1 cm, um das Objekt erstreckt. Vorzugsweise ist das Elektrodenpaar des Sensorelements, insbesondere mittels des Isolierelements, gegenüber der Oberfläche elektrisch isoliert ausgebildet. Beispielsweise ist das Isolierelement als eine Trennschicht aus einem zumindest im Wesentlichen elektrisch isolierenden Material ausgebildet. Es ist denkbar, dass das Sensorelement, insbesondere das Elektrodenpaar, und das Isolierelement einstückig ausgebildet sind, wobei beispielsweise das Sensorelement zumindest größtenteils innerhalb oder an dem Isolierelement angeordnet ist. Unter "einstückig" soll insbesondere stoffschlüssig verbunden, wie beispielsweise durch einen Schweißprozess und/oder Klebeprozess usw., und besonders vorteilhaft angeformt verstanden werden, wie durch die Herstellung in einem Ein- oder Mehrkomponentenspritzverfahren. Besonders bevorzugt ist das Isolierelement wasserdicht ausgebildet. Vorzugsweise ist das Isolierelement dazu vorgesehen, das Sensorelement wasserdicht zu umschließen oder zu zumindest einer Seite, insbesondere in eine, von der Oberfläche zum Sensorelement ausgerichteten Richtung, wasserdicht abzudecken.

Vorzugsweise sind die zwei Elektroden des Elektrodenpaars beabstandet voneinander ausgebildet. Bevorzugt beträgt ein minimaler Abstand der zwei Elektroden höchstens 1,5 mm, vorzugsweise höchstens 1,2 mm und bevorzugt höchstens 1 mm. Insbesondere beträgt der minimale Abstand der zwei Elektroden mindestens 0,2 mm, vorzugsweise mindestens 0,4 mm und bevorzugt mindestens 0,5 mm. Vorzugsweise weist das Sensorelement, insbesondere die zwei Elektroden, eine maximale Dicke von höchstens 3 mm, vorzugsweise höchstens 2,5 mm und bevorzugt höchstens 2 mm, auf. Insbesondere erstrecken sich die zwei Elektroden in einer Haupterstreckungsebene des Sensorelements, die zumindest im Wesentlichen parallel zur Oberfläche ausgerichtet ist. Unter einer "Haupterstreckungsebene" einer Baueinheit, insbesondere des Sensorelements, soll insbesondere eine Ebene verstanden werden, welche parallel zu einer größten Seitenfläche eines kleinsten gedachten Quaders ist, welcher die Baueinheit gerade noch vollständig umschließt, und insbesondere durch den Mittelpunkt des Quaders verläuft. Unter "im Wesentlichen parallel" soll insbesondere eine Ausrichtung einer Geraden, einer Ebene oder einer Richtung, insbesondere der Haupterstreckungsebene des Sensorelements, relativ zu einer anderen Geraden, einer anderen Ebene oder einer Bezugsrichtung, insbesondere einer Ebene durch die Oberfläche, verstanden werden, wobei die Gerade, die Ebene oder die Richtung gegenüber der anderen Geraden, der anderen Ebene oder der Bezugsrichtung, insbesondere in einer Projektionsebene betrachtet, eine Abweichung von insbesondere kleiner als 8°, vorteilhaft kleiner als 5° und besonders vorteilhaft kleiner als 2°, aufweist. Vorzugsweise ist die Oberfläche ebenflächig ausgebildet. Es ist aber auch denkbar, dass die Oberfläche und/oder das Sensorelement, insbesondere die zwei Elektroden, gebogen ausgebildet sind, wobei insbesondere die Oberfläche und das Sensorelement, insbesondere die zwei Elektroden, eine zumindest im Wesentlichen identische Grundform, insbesondere Biegung, aufweisen. Bevorzugt ist die maximale Dicke des Sensorelements, insbesondere der zwei Elektroden, zumindest im Wesentlichen senkrecht zur Haupterstreckungsebene des Sensorelements ausgerichtet. Unter "im Wesentlichen senkrecht" soll insbesondere eine Ausrichtung einer Geraden, einer Ebene oder einer Richtung, insbesondere einer Geraden entlang der maximalen Dicke des Sensorelements, relativ zu einer anderen Geraden, einer anderen Ebene oder einer Bezugsrichtung, insbesondere der Haupterstreckungsebene des Sensorelements, verstanden werden, wobei die Gerade, die Ebene oder die Richtung und die andere Gerade, die andere Ebene oder die Bezugsrichtung, insbesondere in einer Projektionsebene betrachtet, einen Winkel von 90° einschließen und der Winkel eine maximale Abweichung von insbesondere kleiner als 8°, vorteilhaft kleiner als 5° und besonders vorteilhaft kleiner als 2°, aufweist. Bevorzugt ist das Sensorelement, insbesondere die zwei Elektroden, zumindest im Wesentlichen plattenförmig ausgebildet. Unter "im Wesentlichen plattenförmig" soll insbesondere ein Bauteil, insbesondere das Sensorelement, verstanden werden, welches zumindest im Wesentlichen senkrecht zu seiner Haupterstreckungsebene eine zumindest im Wesentlichen gleichbleibende Materialstärke aufweist, die weniger als 50%, vorzugsweise weniger als 25% und besonders bevorzugt weniger als 10% einer Flächenerstreckung, insbesondere einer kleinsten Flächenerstreckung, des Bauteils beträgt, welche zumindest im Wesentlichen parallel zur Haupterstreckungsebene des Bauteils ausgerichtet ist. Es ist aber auch denkbar, dass das Sensorelement, insbesondere die zwei Elektroden, in zumindest einer, insbesondere zumindest im Wesentlichen senkrecht zur Haupterstreckungsebene des Sensorelements ausgerichteten, Schnittebene eine kreisringsegmentförmige und/oder gebogene Grundform aufweist.

Bevorzugt entspricht ein minimaler Abstand der Oberfläche und der zwei Elektroden höchstens 0,8 mm, vorzugsweise höchstens 0,5 mm und bevorzugt höchstens 0,38 mm. Insbesondere entspricht der minimale Abstand der Oberfläche und der zwei Elektroden jeweils einer Dicke des Isolierelements, welches insbesondere zwischen den zwei Elektroden und der Oberfläche angeordnet ist. Insbesondere beträgt der minimale Abstand der Oberfläche und der zwei Elektroden mindestens 0,05 mm, vorzugsweise mindestens 0,15 mm und bevorzugt mindestens 0,3 mm. Bevorzugt ist der minimale Abstand der Oberfläche und der zwei Elektroden über einen Bereich, welcher sich zwischen der Oberfläche und den zwei Elektroden erstreckt, zumindest im Wesentlichen konstant ausgebildet. Unter "im Wesentlichen konstant" soll insbesondere verstanden werden, dass ein Wert einer Kenngröße, insbesondere des minimalen Abstands der Oberfläche und der zwei Elektroden, über einen Bereich und/oder eine Ausdehnung, insbesondere über den Bereich, welcher sich zwischen der Oberfläche und den zwei Elektroden erstreckt, zu einem über den Bereich und/oder die Ausdehnung ermittelten Mittelwert der Kenngröße eine Abweichung von höchstens 10 %, vorzugsweise höchstens 5 % und bevorzugt höchstens 3 %, aufweist. Bevorzugt ist die Sensoreinheit derart ausgebildet, dass ein Objekt, insbesondere ein Regentropfen, das sich im Nahbereich der Oberfläche bewegt oder angeordnet ist und/oder die Oberfläche berührt, einen Wert der Kapazitätskenngröße des Sensorelements, insbesondere des Elektrodenpaars, beeinflusst und/oder ändert. Vorzugsweise sind/ist der minimale Abstand der Oberfläche und der zwei Elektroden und/oder die zwei Elektroden derart ausgebildet, dass sich ein Wert der Kapazitätskenngröße des Sensorelements, insbesondere des Elektrodenpaars, in einem Grundzustand des Sensorelements, insbesondere in Abwesenheit von einem festen Objekt und/oder Regentropfen auf der Oberfläche und/oder lediglich Luft in einem Nahbereich der Oberfläche, bei einer Anordnung eines Regentropfens an der Oberfläche um mindestens 2 %, vorzugsweise mindestens 3 % und bevorzugt mindestens 5 %, ändert, wobei insbesondere der Regentropfen ein Volumen an Wasser von höchstens 0,4 cm³ aufweist.

Bevorzugt ist die Regenerkennungsvorrichtung zu einer Verwendung mit einem Gartengerät, insbesondere einem Rasenmäher, vorgesehen. Insbesondere ist die Regenerkennungsvorrichtung, insbesondere die Auswerteeinheit, dazu vorgesehen, ein Auftreffen von Regentropfen auf der Oberfläche zu erkennen. Vorzugsweise ist die Regenerkennungsvorrichtung als Teil des Gartengeräts ausgebildet, wobei insbesondere das Sensorelement an einer, an einer Oberseite des Gartengeräts angeordneten Außenfläche des Gartengeräts, insbesondere eines Gehäuses des Gartengeräts, angeordnet ist. Besonders bevorzugt ist das Gartengerät als ein teilautonomes Gartengerät, insbesondere als ein teilautonomer Rasenmäher, ausgebildet, wobei insbesondere die Auswerteeinheit als ein Teil einer Steuer- und/oder Regeleinheit des teilautonomen Gartengeräts ausgebildet ist. Unter einer "Steuer- und/oder Regeleinheit" soll insbesondere eine Einheit mit zumindest einer Steuerelektronik verstanden werden. Unter einer "Steuerelektronik" soll insbesondere eine Einheit mit einer Prozessoreinheit und mit einer Speichereinheit sowie mit einem in der Speichereinheit gespeicherten Betriebsprogramm verstanden werden. Vorzugsweise ist das teilautonome Gartengerät, insbesondere die Steuer- und/oder Regeleinheit, dazu vorgesehen und/oder dazu eingerichtet, zumindest eine Tätigkeit, insbesondere einen Mähvorgang oder eine Fortbewegung, in Abhängigkeit von einem Ausgabesignal der Regenerkennungsvorrichtung zu steuern und/oder zu regeln.

Durch die erfindungsgemäße Ausgestaltung der Regenerkennungsvorrichtung kann eine vorteilhaft genaue Erkennung von Regentropfen und/oder eines Regenzustands ermöglicht werden, insbesondere um eine Tätigkeit, wie beispielsweise einen Mähprozess, in Abhängigkeit dieser Erkennung zu steuern und/oder zu regeln. Es kann eine vorteilhaft einfache und genaue Unterscheidung zwischen Regentropfen und anderen, das Sensorelement beeinflussenden Objekten, wie beispielsweise Ästen, Grashalmen, einer Hand oder einem Finger o. dgl. mittels der Auswerteeinheit ermöglicht werden. Es kann eine vorteilhaft einfache und kostengünstige Ausgestaltung des Sensorelements zu einer Erkennung von Regentropfen ermöglicht werden, insbesondere da die Erkennung von Regentropfen und/oder eine Unterscheidung zwischen Regentropfen und anderen Objekten zumindest größtenteils mittels der Auswerteeinheit erfolgen kann/können. Es kann eine vorteilhaft zuverlässige Erkennung von Regentropfen oder eines Regenzustands durch eine kapazitive Messung ermöglicht werden, wobei insbesondere optische Sensoren hohe Kosten hinsichtlich benötigter Komponenten und einer Anordnung an Geräten bedeuten und Widerstandsmessungen freiliegende Kontakte voraussetzen, welche anfällig für Beschädigungen und Verschmutzungen sind. Insbesondere durch die Auswertung des differentiellen Signals kann eine von Änderungen einer Temperatur, einer Luftfeuchtigkeit, einer Staubkonzentration in einer Umgebungsluft o. dgl. vorteilhaft unabhängige Erkennung von Regentropfen und/oder des Regenzustands an der Oberfläche ermöglicht werden.

Des Weiteren wird vorgeschlagen, dass die Symmetriekenngröße als ein Verhältnis einer positiven Gewichtungskenngröße des differentiellen Signals und einer negativen Gewichtungskenngröße des differentiellen Signals ausgebildet ist, wobei die Auswerteeinheit dazu eingerichtet ist, in Abhängigkeit von einer Überschreitung eines Grenzwerts oder eines Grenzbereichs der Symmetriekenngröße einen Regentropfen auf der Oberfläche zu erkennen. Es kann eine vorteilhaft einfache und kostengünstige Ausgestaltung der Auswerteeinheit erreicht werden. Es kann eine vorteilhaft schnelle Erkennung von Regentropfen erreicht werden. Es kann eine vorteilhaft einfache und genaue Unterscheidung zwischen Regentropfen und anderen, das Sensorelement beeinflussenden Objekten, wie beispielsweise Ästen, Grashalmen, einer Hand oder einem Finger o. dgl. ermöglicht werden. Es kann eine durch einen Regentropfen aufgebrachte Flüssigkeitsschicht an dem Sensorelement, insbesondere auf einer Oberfläche des Sensorelements, erkannt werden, welche zu einer Erkennung von Regentropfen und/oder zu einer Unterscheidung zwischen Regentropfen und anderen Objekten herangezogen werden kann. Unter einer "Gewichtungskenngröße" eines Signals, insbesondere des differentiellen Signals, soll insbesondere eine Kenngröße verstanden werden, die einen zeitlichen Verlauf des Signals anhand einer spezifischen Gewichtung relativ zu einem Bezugspunkt, insbesondere einem Nullpunkt, beschreibt und/oder angibt. Vorzugsweise ist die positive Gewichtungskenngröße als ein, insbesondere absolutes, Maximum des differentiellen Signals innerhalb eines ausgewerteten Zeitintervalls, als ein positiver Anteil eines Integrals des differentiellen Signals über das ausgewertete Zeitintervall oder als eine Summe von lokalen Maxima innerhalb des ausgewerteten Zeitintervalls ausgebildet. Bevorzugt ist die negative Gewichtungskenngröße als ein, insbesondere absolutes, Minimum des differentiellen Signals innerhalb des ausgewerteten Zeitintervalls, als ein negativer Anteil eines Integrals des differentiellen Signals über das ausgewertete Zeitintervall oder als eine Summe von lokalen Minima innerhalb des ausgewerteten Zeitintervalls ausgebildet. Vorzugsweise umfasst die Auswerteeinheit zumindest einen Algorithmus zu einem Erkennen von Regentropfen auf der Oberfläche und/oder zu einem Erkennen eines Regenzustands an der Oberfläche mittels über das Sensorelement erfassten Signalen. Insbesondere beschreibt der Regenzustand gemäß einem vorgegebenen Grenzwert für eine Anzahl an mittels der Auswerteeinheit erkannten Regentropfen innerhalb eines vorgegebenen Zeitraums, ob es regnet oder nicht. Vorzugsweise ist die Auswerteeinheit, insbesondere der Algorithmus, dazu eingerichtet, zum Erkennen von Regentropfen auf der Oberfläche das Verhältnis der positiven Gewichtungskenngröße des differentiellen Signals und der negativen Gewichtungskenngröße des differentiellen Signals mit dem zumindest einen Grenzwert oder dem Grenzbereich der Symmetriekenngröße zu vergleichen. Insbesondere ist der Grenzwert oder der Grenzbereich der Symmetriekenngröße in der Auswerteeinheit hinterlegt. Es ist denkbar, dass der Grenzwert oder der Grenzbereich der Symmetriekenngröße bei einer Herstellung oder einer Wartung der Regenerkennungsvorrichtung vorgegeben wird und/oder mittels der Auswerteeinheit, insbesondere dem Algorithmus dynamisch, beispielsweise mittels eines maschinellen Lernverfahrens, angepasst wird. Es ist auch denkbar, dass der Grenzwert oder der Grenzbereich der Symmetriekenngröße über eine Bedienerschnittstelle der Regenerkennungsvorrichtung oder des Gartengeräts durch einen Benutzer einstellbar ist. In einer bevorzugten Ausgestaltung beträgt der Grenzwert der als Verhältnis der positiven Gewichtungskenngröße und der negativen Gewichtungskenngröße ausgebildeten Symmetriekenngröße mindestens 2, vorzugsweise mindestens 3 und bevorzugt mindestens 4, wobei insbesondere das ausgewertete Zeitintervall mindestens 2 s, vorzugsweise mindestens 3 s und bevorzugt mindestens 4 s und/oder höchstens 10 s, vorzugsweise höchstens 8 s und bevorzugt höchstens 5 s, beträgt. Alternativ oder zusätzlich ist die Auswerteeinheit dazu vorgesehen, bei einer Erkennung von mindestens 2, vorzugsweise mindestens 3 und bevorzugt mindestens 4 Regentropfen auf der Oberfläche innerhalb eines Zeitintervalls von mindestens 2 s, vorzugsweise mindestens 3 s und bevorzugt mindestens 4 s und/oder höchstens 10 s, vorzugsweise höchstens 8 s und bevorzugt höchstens 5 s, einen Regenzustand zu erkennen.

Zudem wird vorgeschlagen, dass die Auswerteeinheit dazu eingerichtet ist, das differentielle Signal in Zeitintervallen, insbesondere kontinuierlich, stückweise auszuwerten und für jedes ausgewertete Zeitintervall genau einen booleschen Wert eines Regenzustands an der Oberfläche auszugeben. Es kann eine vorteilhaft einfache Auslese der Regenerkennungsvorrichtung ermöglicht werden, beispielsweise durch einen Benutzer und/oder eine Ausleseelektronik eines vorrichtungsexternen Geräts. Dadurch kann eine vorteilhaft einfache und kostengünstige Ausleseelektronik ermöglicht werden. Es kann eine vorteilhaft benutzerfreundliche Bedienung der Regenerkennungsvorrichtung erreicht werden, insbesondere da der Benutzer zum Auslesen der Regenerkennungsvorrichtung lediglich zwischen zwei möglichen Ausgaben unterscheiden muss. Unter einem "booleschen Wert" soll insbesondere ein Wert einer Wertemenge verstanden werden, welche genau zwei verschiedene Werte umfasst. Insbesondere gibt ein boolescher Wert des Regenzustands einen Regenzustand an der Oberfläche an. Vorzugsweise gibt ein anderer boolescher Wert des Regenzustands eine Abwesenheit des Regenzustands an der Oberfläche an. Vorzugsweise betragen die Zeitintervalle jeweils mindestens 2 s, vorzugsweise mindestens 3 s und bevorzugt mindestens 4 s und/oder höchstens 10 s, vorzugsweise höchstens 8 s und bevorzugt höchstens 5 s. Bevorzugt sind die Zeitintervalle hintereinander angeordnet, wobei insbesondere die Auswerteeinheit dazu eingerichtet ist, das kontinuierliche differentielle Signal in die Zeitintervalle aufzuteilen. Alternativ ist auch denkbar, dass die Auswerteeinheit dazu vorgesehen ist, das differentielle Signal in periodischen Abständen über jeweils ein Zeitintervall auszuwerten. Vorzugsweise ist die Auswerteeinheit dazu eingerichtet, eine Anzahl an erkannten und/oder identifizierten Regentropfen für jedes ausgewertete Zeitintervall zu ermitteln. Insbesondere ist die Auswerteeinheit dazu eingerichtet, bei einer Überschreitung eines Grenzwerts der Anzahl an innerhalb des Zeitintervalls erkannten und/oder identifizierten Regentropfen den Regenzustand an der Oberfläche zu erkennen. Bevorzugt ist die Auswerteeinheit dazu eingerichtet, bei einem Erkennen des Regenzustands an der Oberfläche, ein den booleschen Wert des Regenzustands umfassendes Ausgabesignal auszugeben.

Ferner wird vorgeschlagen, dass die Auswerteeinheit dazu eingerichtet ist, in Abhängigkeit von der Erkennung von Regentropfen auf der Oberfläche zumindest ein Ausgabesignal, insbesondere einen booleschen Wert eines Regenzustands an der Oberfläche, auszugeben, wobei die Auswerteeinheit dazu eingerichtet ist, eine Ausgabe des Ausgabesignals und/oder eine Änderung des Ausgabesignals zeitlich zu limitieren. Es können Fehlfunktionen der Regenerkennungsvorrichtung und/oder eines in Abhängigkeit eines Ausgangssignals der Regenerkennungsvorrichtung gesteuerten Geräts, beispielsweise durch eine zu häufige Ausgabe an Werten des Regenzustands, vorteilhaft verhindert werden. Es kann eine vorteilhaft einfache Auslese der Regenerkennungsvorrichtung ermöglicht werden, beispielsweise durch einen Benutzer und/oder eine Ausleseelektronik eines vorrichtungsexternen Geräts. Dadurch kann eine vorteilhaft einfache und kostengünstige Ausleseelektronik ermöglicht werden. Bevorzugt ist die Auswerteeinheit dazu eingerichtet, eine Anzahl an ausgegebenen Werten, insbesondere den booleschen Werten, des Regenzustands und/oder an Ausgabevorgängen des Regenzustands zeitlich zu begrenzen. Bevorzugt ist die Auswerteeinheit dazu eingerichtet einen, insbesondere booleschen, ausgegebenen Wert des Regenzustands zumindest über ein Zeitintervall zu speichern und erst nach Ablauf dieses Zeitintervalls einen weiteren Wert des Regenzustands auszugeben, wobei das Zeitintervall mindestens 2 s, vorzugsweise mindestens 3 s und bevorzugt mindestens 4 s und/oder höchstens 1 min, vorzugsweise höchstens 30 s und bevorzugt höchstens 10 s, beträgt. Vorzugsweise umfasst das Ausgabesignal zumindest den durch die Auswerteeinheit ermittelten booleschen Wert. Insbesondere ist die Auswerteeinheit dazu eingerichtet, das Ausgabesignal an eine externe Einheit, beispielsweise die Steuer- und/oder Regeleinheit oder eine andere Komponente des Gartengeräts, ein Smart-Home System oder eine andere, dem Fachmann sinnvoll erscheinende externe Einheit, auszugeben. Es ist denkbar, dass die Regenerkennungsvorrichtung und/oder das Gartengerät zumindest eine Kommunikationseinheit umfassen, die dazu vorgesehen ist, das Ausgabesignal an die externe Einheit zu übertragen. Beispielsweise ist die Kommunikationseinheit als eine Funk-, eine W-LAN- oder eine Bluetooth-Schnittstelle oder eine andere, einem Fachmann bekannte Kommunikationsschnittstelle ausgebildet.

Des Weiteren wird vorgeschlagen, dass das kapazitive Sensorelement zumindest ein, insbesondere genau ein, Elektrodenpaar ausbildet, welches zumindest elektrisch mit der Auswerteeinheit verbunden ist, wobei das Elektrodenpaar eine maximale Erfassungsfläche aufspannt, die mindestens 12 cm², vorzugsweise mindestens 16 cm² und bevorzugt mindestens 20 cm², beträgt. Es kann eine vorteilhaft große Oberfläche zur Erkennung von Regentropfen ermöglicht werden, die insbesondere groß genug ist, um eine von einem Regentropfen hinterlassene Flüssigkeitsschicht auf der Oberfläche zu erkennen. Es kann eine Ausgestaltung der Regenerkennungsvorrichtung mit lediglich einem Sensorelement ermöglicht werden. Dadurch kann eine vorteilhaft kostengünstige Ausgestaltung erreicht werden, insbesondere hinsichtlich einer vorteilhaft geringen Anzahl an Bauteilen und/oder einer Ausgestaltung der Auswerteeinheit, über die lediglich ein Sensorelement, insbesondere Signale eines Sensorelements, ausgelesen werden. Insbesondere beträgt die maximale Erfassungsfläche des Sensorelements, insbesondere des Elektrodenpaars, höchstens 100 cm², vorzugsweise höchstens 50 cm² und bevorzugt höchstens 30 cm². Vorzugsweise entspricht die Oberfläche der Sensoreinheit, insbesondere des Isolierelements, zumindest der maximalen Erfassungsfläche des Sensorelements, insbesondere des Elektrodenpaars. Vorzugsweise ist die maximale Erfassungsfläche des Sensorelements, insbesondere des Elektrodenpaars, zumindest im Wesentlichen parallel zur Oberfläche angeordnet. Bevorzugt ist die maximale Erfassungsfläche des Sensorelements, insbesondere des Elektrodenpaars, als eine Fläche ausgebildet, welche das Elektrodenpaar gerade noch vollständig einschließt. Insbesondere ist ein minimaler Abstand zwischen den zwei Elektroden des Elektrodenpaars innerhalb der maximalen Erfassungsfläche des Sensorelements, insbesondere des Elektrodenpaars, angeordnet. Bevorzugt sind/ist das Elektrodenpaar und/oder die maximale Erfassungsfläche des Sensorelements, insbesondere des Elektrodenpaars, derart angeordnet, dass ein minimaler Abstand der zwei Elektroden über die maximale Erfassungsfläche des Sensorelements, insbesondere des Elektrodenpaars, zumindest im Wesentlichen konstant ausgebildet ist. Bevorzugt weist das Sensorelement, insbesondere das Elektrodenpaar, in dem Grundzustand des Sensorelements, insbesondere in Abwesenheit von einem festen Objekt und/oder Regentropfen auf der Oberfläche und/oder lediglich Luft in einem Nahbereich der Oberfläche, eine Kapazitätskenngröße von mindestens 5 pF, vorzugsweise mindestens 10 pF und bevorzugt mindestens 12 pF, auf. Bevorzugt entspricht die Kapazitätskenngröße im Grundzustand einem Wert von zumindest im Wesentlichen 12,8 pF. Insbesondere beträgt die Kapazitätskenngröße im Grundzustand höchstens 50 pF, vorzugsweise höchstens 30 pF und bevorzugt höchstens 20 pF.

Zudem wird vorgeschlagen, dass die Sensoreinheit zumindest teilweise als eine, insbesondere zumindest im Wesentlichen biegeschlaffe, flexible Membran ausgebildet ist, welche zumindest elektrisch mit der Auswerteeinheit verbunden ist. Es kann eine vorteilhaft hohe Flexibilität hinsichtlich einer Befestigung und/oder eines Einsatzbereichs des Sensorelements an einem Gerät erreicht werden. Es kann eine vorteilhaft robuste Ausgestaltung des Sensorelements erreicht werden. Es kann eine vorteilhaft hohe Modularität des Sensormoduls mit einer Vielzahl von verschieden ausgebildeten Geräten erreicht werden. Dadurch können vorteilhaft geringe Herstellungskosten ermöglicht werden, insbesondere da lediglich eine Bauweise des Sensorelements hergestellt werden kann. Unter "im Wesentlichen biegeschlaff" soll insbesondere ein Bauteil, insbesondere die Sensoreinheit, verstanden werden, welches ein Elastizitätsmodul von mindestens 200 GPa, vorzugsweise mindestens 300 GPa und bevorzugt mindestens 400 GPa, aufweist. Insbesondere ist das Isolierelement aus einem, insbesondere zumindest im Wesentlichen biegeschlaffen, flexiblen Material, wie beispielsweise einem Kunststoff, Gummi, o. dgl., ausgebildet, wobei insbesondere das Elektrodenpaar an einer Seite auf dem Isolierelement aufliegt und/oder zumindest größtenteils, insbesondere zumindest im Wesentlichen vollständig innerhalb des Isolierelements angeordnet, beispielsweise eingegossen und/oder eingebettet, ist. Bevorzugt ist das Sensorelement derart ausgebildet, dass eine Änderung eines minimalen Abstands der Elektroden des Elektrodenpaars bei einem Verformen, insbesondere Biegen, des Sensorelements und/oder des Isolierelements zumindest im Wesentlichen verhindert wird. In einer bevorzugten Ausgestaltung ist das Elektrodenpaar über einen Siebdruck auf ein flexibles Isolierelement aufgebracht, wobei insbesondere das Elektrodenpaar zwischen dem Isolierelement und einem weiteren flexiblen Isolierelement der Sensoreinheit angeordnet ist. Insbesondere ist das Elektrodenpaar mit Ausnahme von zwei elektrischen Kontakten des Elektrodenpaars zu einer Verbindung mit der Auswerteeinheit zumindest im Wesentlichen vollständig von dem Isolierelement und dem weiteren Isolierelement umschlossen.

Außerdem wird ein Gartengerät, insbesondere ein Rasenmäher, mit zumindest einer erfindungsgemäßen Regenerkennungsvorrichtung vorgeschlagen.

Durch die erfindungsgemäße Ausgestaltung des Gartengeräts kann eine vorteilhaft genaue Erkennung von Regentropfen und/oder eines Regenzustands ermöglicht werden, insbesondere um das Gartengerät wetterspezifisch zu steuern und/oder zu regeln. Es kann eine vorteilhaft einfache und genaue Unterscheidung zwischen Regentropfen und anderen, das Sensorelement beeinflussenden Objekten, wie beispielsweise Ästen, Grashalmen, einer Hand oder einem Finger o. dgl. mittels der Auswerteeinheit ermöglicht werden. Dadurch kann eine vorteilhaft hohe Flexibilität des Gartengeräts, insbesondere hinsichtlich einer Einsatzumgebung, beispielsweise in hohem Gras o. dgl., ermöglicht werden. Es kann eine vorteilhaft einfache und kostengünstige Ausgestaltung des Gartengeräts, insbesondere des Sensorelements der Regenerkennungsvorrichtung zu einer Erkennung von Regentropfen, ermöglicht werden, insbesondere da die Erkennung von Regentropfen und/oder eine Unterscheidung zwischen Regentropfen und anderen Objekten zumindest größtenteils mittels der Auswerteeinheit erfolgen kann/können.

Zusätzlich geht die Erfindung aus von einem Verfahren zu einer Erfassung von Regentropfen auf einer Oberfläche mittels einer Regenerkennungsvorrichtung, insbesondere einer erfindungsgemäßen Regenerkennungsvorrichtung, wobei in zumindest einem Verfahrensschritt mittels eines kapazitiven Sensorelements der Regenerkennungsvorrichtung eine Kapazitätskenngröße erfasst wird, wobei in zumindest einem Verfahrensschritt mittels einer Auswerteeinheit der Regenerkennungsvorrichtung in Abhängigkeit von einem differentiellen Signal des Sensorelements eine Erkennung von Regentropfen auf der Oberfläche erfolgt.

Es wird vorgeschlagen, dass in zumindest einem Verfahrensschritt die Erkennung von Regentropfen auf der Oberfläche mittels der Auswerteeinheit in Abhängigkeit von einer Symmetriekenngröße des differentiellen Signals, insbesondere gegenüber einem Nullpunkt, erfolgt. Vorzugsweise wird in zumindest einem Verfahrensschritt das differentielle Signal mittels der Auswerteeinheit in Zeitintervallen, insbesondere kontinuierlich, stückweise ausgewertet, wobei für jedes ausgewertete Zeitintervall genau ein boolescher Wert eines Regenzustands an der Oberfläche ausgegeben wird.

Durch die erfindungsgemäße Ausgestaltung des Verfahrens kann eine vorteilhaft genaue Erkennung von Regentropfen und/oder eines Regenzustands ermöglicht werden, insbesondere um eine Tätigkeit, wie beispielsweise einen Mähprozess, in Abhängigkeit dieser Erkennung zu steuern und/oder zu regeln. Es kann eine vorteilhaft einfache und genaue Unterscheidung zwischen Regentropfen und anderen, das Sensorelement beeinflussenden Objekten, wie beispielsweise Ästen, Grashalmen, einer Hand oder einem Finger o. dgl. ermöglicht werden. Es kann eine vorteilhaft einfache und kostengünstige Ausgestaltung des Sensorelements zu einer Erkennung von Regentropfen ermöglicht werden, insbesondere da die Erkennung von Regentropfen und/oder eine Unterscheidung zwischen Regentropfen und anderen Objekten zumindest größtenteils mittels der Auswerteeinheit erfolgen kann/können.

Zudem wird vorgeschlagen, dass in zumindest einem Verfahrensschritt das kontinuierliche differentielle Signal mittels der Auswerteeinheit zur Erkennung von Regentropfen auf der Oberfläche in Abhängigkeit von zumindest einer Gewichtungskenngröße des differentiellen Signals über ein vorgegebenes oder ein dynamisches Zeitintervall ausgewertet wird. Es kann eine vorteilhaft benutzer- und/oder umgebungsspezifische Einstellung der Regenerkennungsvorrichtung ermöglicht werden. Insbesondere kann eine vorteilhaft benutzerspezifische und/oder individualisierbare Erkennung von Regentropfen erreicht werden. Insbesondere über eine dynamische Ermittlung des Zeitintervalls kann eine vorteilhaft automatische Anpassung der Auswerteeinheit an eine Umgebung und/oder an Wetterbedingungen ermöglicht werden. Es ist denkbar, dass das Zeitintervall mittels der Auswerteeinheit, insbesondere des Algorithmus, in Abhängigkeit von einer über die Auswerteeinheit ermittelten Anzahl an lokalen Maxima und/oder Minima des differentiellen Signals im Zeitintervall, von einem über die Auswerteeinheit ermittelten Integral des differentiellen Signals über das Zeitintervall o. dgl. dynamisch angepasst wird.

Ferner wird vorgeschlagen, dass in zumindest einem Verfahrensschritt, insbesondere vor einer Auswertung zur Erkennung von Regentropfen auf der Oberfläche, das differentielle Signal mittels der Auswerteeinheit nach Störsignalen gefiltert wird. Es können vorteilhaft Störsignale in an die Auswerteeinheit übertragenen Signalen des Sensorelements verhindert und/oder reduziert werden. Es kann hoch-frequentes Rauschen im differentiellen Signal des Sensorelements vorteilhaft verhindert und/oder reduziert werden. Dadurch kann eine vorteilhaft genaue und schnelle Erkennung von Regentropfen und/oder des Regenzustands mittels der Auswerteeinheit ermöglicht werden. Vorzugsweise ist die Auswerteeinheit dazu eingerichtet, von dem Sensorelement übertragene Werte der Kapazitätskenngröße oder das differentielle Signal derart zu filtern, dass Werte unter einem Filtergrenzwert der Kapazitätskenngröße oder des differentiellen Signals zu einer Auswertung und/oder der Erkennung von Regentropfen auf der Oberfläche entfernt werden und/oder nicht berücksichtigt werden. Es ist auch denkbar, dass mittels der Auswerteeinheit, insbesondere des Algorithmus, die von dem Sensorelement übertragenen Werte der Kapazitätskenngröße oder das differentielle Signal nach zumindest einem vorgegebenen Signalmuster gefiltert werden/wird, welches insbesondere in der Auswerteeinheit hinterlegt ist. Insbesondere ist jedem zu filternden Störsignal zumindest ein Signalmuster zugeordnet. Es ist auch denkbar, dass die Auswerteeinheit einen Hochpass- und/oder einen Tiefpass-Filter umfasst, die/der dazu vorgesehen sind/ist, Teile des differentiellen Signals, welche insbesondere ein Störsignal umfassen, zu filtern, insbesondere vor der Auswertung mittels der Auswerteeinheit zur Erkennung von Regentropfen auf der Oberfläche aus dem differentiellen Signal zu entfernen. Vorzugsweise werden mittels der Auswerteeinheit Werte der Kapazitätskenngröße und/oder des differentiellen Signals unter einem Grenzwert von mindestens 3 fF, vorzugsweise mindestens 6 fF und bevorzugt mindestens 10 fF, gefiltert und/oder aus einem Datenstrom entfernt.

Des Weiteren wird vorgeschlagen, dass in zumindest einem Verfahrensschritt mittels einer Steuer- und/oder Regeleinheit der Regenerkennungsvorrichtung oder des Gartengeräts zumindest ein Auswertungsparameter der Auswerteeinheit in Abhängigkeit von einer, insbesondere über die Auswerteeinheit, automatisch ermittelten und/oder vorgegebenen Sensitivitätskenngröße angepasst wird. Es kann eine vorteilhaft hohe Benutzerfreundlichkeit ermöglicht werden, insbesondere da eine Sensitivität einer Erkennung von Regentropfen und/oder des Regenzustands vorteilhaft schnell und einfach durch den Benutzer einstellbar ist.

Es kann eine vorteilhaft individuelle Verwendung der Regenerkennungsvorrichtung ermöglicht werden. Es kann eine vorteilhaft hohe Flexibilität der Regenerkennungsvorrichtung hinsichtlich einer Umgebung, Wetterbedingungen und/oder Jahreszeiten erreicht werden, wobei ohne eine Wartung oder Demontage der Regenerkennungsvorrichtung oder ohne einen Fachmann der zumindest eine Auswertungsparameter eingestellt werden kann. Insbesondere umfasst die Steuer- und/oder Regeleinheit eine Mehrzahl von verschiedenen Werten der Sensitivitätskenngröße. Vorzugsweise umfasst die Auswerteeinheit für den Auswertungsparameter, insbesondere alle Auswertungsparameter, der Auswerteeinheit jeweils zumindest einen Wert, welcher einem Wert der Sensitivitätskenngröße zugeordnet ist. Bevorzugt werden bei einer Auswahl eines Werts der Sensitivitätskenngröße durch einen Benutzer und/oder die Steuer- und/oder Regeleinheit der/die Auswertungsparameter auf den/die dem Wert der Sensitivitätskenngröße zugeordneten Wert(e) eingestellt. Beispielsweise ist der Auswertungsparameter als eine Länge des Zeitintervalls oder der Zeitintervalle, als ein Grenzwert oder Grenzbereich der Symmetriekenngröße, als ein Filtergrenzwert der Kapazitätskenngröße oder des differentiellen Signals o. dgl. ausgebildet. Alternativ oder zusätzlich wird die Sensitivitätskenngröße in zumindest einem Verfahrensschritt mittels der Bedienerschnittstelle der Regenerkennungsvorrichtung oder des Gartengeräts eingestellt, wobei insbesondere der zumindest eine Auswertungsparameter mittels der Auswerteeinheit auf einen, einem Wert der eingestellten Sensitivitätskenngröße zugeordneten Wert geändert wird. Es ist auch denkbar, dass über die Sensitivitätskenngröße eine Erkennung von Regentropfen und/oder des Regenzustands zumindest zeitweise ausgesetzt werden kann, wobei insbesondere kein Ausgangssignal ausgegeben wird. Insbesondere ist denkbar, dass über eine Anpassung des Auswertungsparameters eine Erkennung von Regentropfen in Abhängigkeit von einer Größe der Regentropfen, einer Frequenz von Einschlägen der Regentropfen auf der Oberfläche und/oder einer Dichte der Regentropfen eingestellt wird. In einer beispielhaften Ausgestaltung sind jeder Sensitivitätskenngröße ein Wert eines Grenzwerts der Symmetriekenngröße und ein Wert eines Grenzwerts der Anzahl an erkannten Regentropfen innerhalb eines ausgewerteten Zeitintervalls zugeordnet. Insbesondere werden die Werte des Grenzwerts der Symmetriekenngröße und des Grenzwerts der Anzahl an erkannten Regentropfen innerhalb des ausgewerteten Zeitintervalls mittels der Auswerteeinheit angepasst, falls die zugehörige Sensitivitätskenngröße, insbesondere durch einen Benutzer oder eine externe Einheit, eingestellt wird.

Die erfindungsgemäße Regenerkennungsvorrichtung, das erfindungsgemäße Gartengerät und/oder das erfindungsgemäße Verfahren sollen/soll hierbei nicht auf die oben beschriebene Anwendung und Ausführungsform beschränkt sein. Insbesondere können/kann die erfindungsgemäße Regenerkennungsvorrichtung, das erfindungsgemäße Gartengerät und/oder das erfindungsgemäße Verfahren zu einer Erfüllung einer hierin beschriebenen Funktionsweise eine von einer hierin genannten Anzahl von einzelnen Elementen, Bauteilen und Einheiten sowie Verfahrensschritten abweichende Anzahl aufweisen. Zudem sollen bei den in dieser Offenbarung angegebenen Wertebereichen auch innerhalb der genannten Grenzen liegende Werte als offenbart und als beliebig einsetzbar gelten.

### Zeichnungen

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Darstellung eines erfindungsgemäßen Gartengeräts mit einer erfindungsgemäßen Regenerkennungsvorrichtung,
- Fig. 2: eine Prinzipskizze der erfindungsgemäßen Regenerkennungsvorrichtung,
- Fig. 3: eine schematische Schnittansicht einer Sensoreinheit der erfindungsgemäßen Regenerkennungsvorrichtung als eine Draufsicht,
- Fig. 4: eine schematische Schnittansicht der Sensoreinheit der erfindungsgemäßen Regenerkennungsvorrichtung als eine Seitenansicht,
- Fig. 5: eine schematische Darstellung eines Ablaufs eines erfindungsgemäßen Verfahrens zu einer Erfassung von Regentropfen auf einer Oberfläche mittels der erfindungsgemäßen Regenerkennungsvorrichtung,
- Fig. 6: eine schematische Darstellung eines Ablaufs eines Algorithmus der erfindungsgemäßen Regenerkennungsvorrichtung, welcher mittels einer Auswerteeinheit der Regenerkennungsvorrichtung ausführbar ist,
- Fig. 7: eine beispielhafte Messung eines zeitlichen Verlaufs einer Kapazitätskenngröße des Sensorelements bei einem Aufschlag eines Regentropfens auf der Oberfläche und
- Fig. 8: eine beispielhafte Messung eines zeitlichen Verlaufs eines differentiellen Signals des Sensorelements während eines Regenzustands.

### Beschreibung des Ausführungsbeispiels

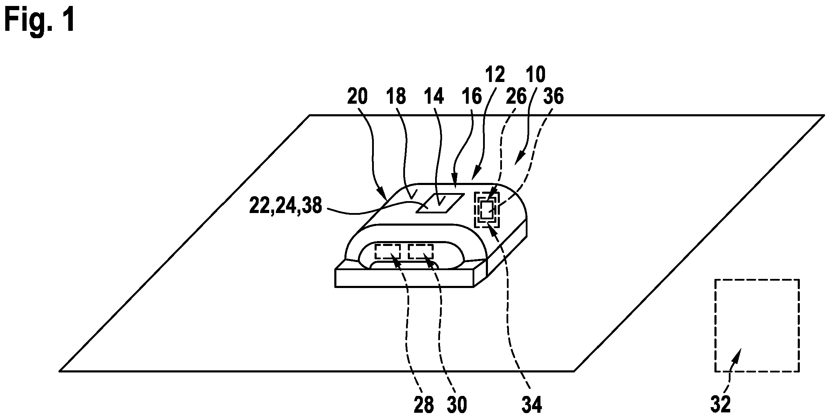

In Figur 1 ist ein Gartengerät 10 mit einer Regenerkennungsvorrichtung 12 gezeigt. Das Gartengerät 10 ist als ein teilautonomer Rasenmäher, insbesondere als Rasenmähroboter, ausgebildet. Insbesondere ist das als Rasenmäher ausgebildete Gartengerät 10 bewegbar ausgebildet. Es sind aber auch andere Ausgestaltungen des Gartengeräts 10 denkbar, beispielsweise als ein stationäres Gerät, wie ein Rasensprenger o. dgl. Die Regenerkennungsvorrichtung 12 ist zu einer Erfassung von Regentropfen auf einer Oberfläche 14 vorgesehen. Die Oberfläche 14 ist als Teil der Regenerkennungsvorrichtung 12, insbesondere einer Sensoreinheit 16 der Regenerkennungsvorrichtung 12, ausgebildet. Die Oberfläche 14 ist insbesondere an einer Außenfläche 18 eines Gehäuses 20 des Gartengeräts 10 angeordnet. Die Oberfläche 14 ist an einer Oberseite des Gartengeräts 10 angeordnet. Die Regenerkennungsvorrichtung 12 umfasst die Sensoreinheit 16, die genau ein kapazitives Sensorelement 22 umfasst, wobei das Sensorelement 22 derart ausgebildet und/oder angeordnet ist, dass sich eine Kapazitätskenngröße des Sensorelements 22 in Abhängigkeit von einer Kontaktierung der Oberfläche 14 mittels eines Objekts, beispielsweise eines Regentropfens, ändert. Die Kapazitätskenngröße ist als eine elektrische Kapazität eines Elektrodenpaars 24 ausgebildet, welches das Sensorelement 22 ausbildet. Die Regenerkennungsvorrichtung 12 umfasst eine Auswerteeinheit 26, die dazu eingerichtet ist, in Abhängigkeit von einem differentiellen Signal des Sensorelements 22 Regentropfen auf der Oberfläche 14 zu erkennen. Das differentielle Signal ist als ein zeitlicher Verlauf einer Änderungsrate der Kapazitätskenngröße des Sensorelements 22 ausgebildet. Das Gartengerät 10 umfasst eine Bedienerschnittstelle 28 zu einer Benutzerinteraktion. Das Gartengerät 10 umfasst eine Kommunikationseinheit 30 zu einer Datenübertragung zwischen dem Gartengerät 10, insbesondere der Regenerkennungsvorrichtung 12, und einer externen Einheit 32. Die externe Einheit 32 ist als ein Smart-Home System ausgebildet. Es sind aber auch andere Ausgestaltungen der externen Einheit 32 denkbar, beispielsweise als ein Netzwerk, eine Internetverbindung, ein anderes Gartengerät 10 o. dgl. Insbesondere ist die Kommunikationseinheit 30 als eine W-LAN-Schnittstelle ausgebildet. Es sind aber auch andere Ausgestaltungen der Kommunikationseinheit 30 denkbar, beispielsweise als eine Bluetooth-Schnittstelle, als eine optische Schnittstelle, als eine kabelgebundene Kommunikationseinheit o. dgl. Es sind auch andere Ausgestaltungen des Gartengeräts 10 und/oder der Regenerkennungsvorrichtung 12 denkbar, wobei beispielsweise die Regenerkennungsvorrichtung 12, insbesondere unabhängig von dem Gartengerät 10, eine Bedienerschnittstelle 28 und/oder eine Kommunikationseinheit 30 umfasst.

Insbesondere ist die Regenerkennungsvorrichtung 12, insbesondere die Auswerteeinheit 26, dazu vorgesehen, ein Auftreffen von Regentropfen auf der Oberfläche 14 zu erkennen. Die Regenerkennungsvorrichtung 12 ist als Teil des Gartengeräts 10 ausgebildet. Das Gartengerät 10 umfasst eine Steuer- und/oder Regeleinheit 34, die dazu eingerichtet ist, das Gartengerät 10, insbesondere eine Tätigkeit und/oder eine Fortbewegung des Gartengeräts 10, teilautonom zu steuern und/oder zu regeln. Die Auswerteeinheit 26 ist als ein Teil der Steuer- und/oder Regeleinheit 34 des teilautonomen Gartengeräts 10 ausgebildet. Es ist aber auch denkbar, insbesondere in einer nicht-autonomen Ausgestaltung des Gartengeräts 10, dass die Regenerkennungsvorrichtung 12 eine, insbesondere separate, Steuer- und/oder Regeleinheit 34 umfasst. Vorzugsweise ist das teilautonome Gartengerät 10, insbesondere die Steuer- und/oder Regeleinheit 34, dazu vorgesehen und/oder dazu eingerichtet, zumindest eine Tätigkeit, insbesondere einen Mähvorgang oder eine Fortbewegung, in Abhängigkeit von einem Ausgabesignal der Regenerkennungsvorrichtung 12 zu steuern und/oder zu regeln.

Vorzugsweise sind die Auswerteeinheit 26 und die Steuer- und/oder Regeleinheit 34 als eine Elektronikeinheit, insbesondere als eine bestückte Elektronikplatine, ausgebildet. Es ist aber auch denkbar, dass die Auswerteeinheit 26 getrennt von der Steuer- und/oder Regeleinheit 34, insbesondere als eine bestückte Elektronikplatine, ausgebildet ist. Die Auswerteeinheit 26 umfasst einen Mikrocontroller 36 zu einer Auswertung von über die Sensoreinheit 16, insbesondere das Sensorelement 22, erfassten Signalen. Die Auswerteeinheit 26, insbesondere der Mikrocontroller 36, ist zumindest elektrisch und/oder elektronisch mit der Sensoreinheit 16, insbesondere dem Sensorelement 22, verbunden. Die Auswerteeinheit 26, insbesondere der Mikrocontroller 36, ist dazu eingerichtet, zur Erkennung von Regentropfen auf der Oberfläche 14 die über die Sensoreinheit 16, insbesondere das Sensorelement 22, erfassten Signale, insbesondere die Kapazitätskenngröße und/oder das differentielle Signal, zumindest im Wesentlichen kontinuierlich auszulesen und insbesondere auszuwerten. Besonders bevorzugt ist die Auswerteeinheit 26, insbesondere der Mikrocontroller 36, dazu eingerichtet, das differentielle Signal des Sensorelements 22 in Abhängigkeit von der, insbesondere von dem Sensorelement 22 an die Auswerteeinheit 26 übertragenen, Kapazitätskenngröße zu generieren. Vorzugsweise ist die Auswerteeinheit 26 dazu eingerichtet, zu einer Generierung des differentiellen Signals, insbesondere einer Berechnung eines Werts des differentiellen Signals, jeweils, insbesondere kontinuierlich, zumindest einen Wert der Kapazitätskenngröße mit einem zuvor erfassten anderen Wert der Kapazitätskenngröße zu subtrahieren, wobei insbesondere ein Wert des differentiellen Signals ermittelt wird. Es ist denkbar, dass die Auswerteeinheit 26 dazu eingerichtet ist, das differentielle Signal, insbesondere die Werte des differentiellen Signals, schalttechnisch oder elektronisch, insbesondere mittels des Mikrocontrollers 36, zu generieren, zu ermitteln und/oder zu berechnen. Alternativ sind Ausgestaltungen der Regenerkennungsvorrichtung 12 denkbar, wobei die Sensoreinheit 16 dazu vorgesehen ist, das differentielle Signal zu generieren und an die Auswerteeinheit 26 zu übertragen.

Insbesondere umfasst die Regenerkennungsvorrichtung 12 genau ein kapazitives Sensorelement 22, welches insbesondere zumindest ein, vorzugsweise genau ein, Elektrodenpaar 24 ausbildet. Es sind aber auch andere Ausgestaltungen der Sensoreinheit 16 denkbar, beispielsweise mit mehr als einem Sensorelement 22 und/oder mit mehr als einem Elektrodenpaar 24 des Sensorelements 22/der Sensorelemente 22. Die Oberfläche 14 ist beabstandet von dem Elektrodenpaar 24 des Sensorelements 22 angeordnet. Insbesondere ist die Oberfläche 14 als eine Außenfläche der Sensoreinheit 16, insbesondere eines Isolierelements 38 der Sensoreinheit 16, ausgebildet und/oder in einem Nahbereich des Sensorelements 22, insbesondere des Elektrodenpaars 24, angeordnet. Das Elektrodenpaar 24 des Sensorelements 22 ist mittels des Isolierelements 38 gegenüber der Oberfläche 14 elektrisch isoliert ausgebildet. Beispielsweise ist das Isolierelement 38 als eine Trennschicht aus einem zumindest im Wesentlichen elektrisch isolierenden Material ausgebildet. Die Auswerteeinheit 26 ist dazu eingerichtet, in Abhängigkeit von einer Symmetriekenngröße des differentiellen Signals, insbesondere gegenüber einem Nullpunkt, einen Regentropfen auf der Oberfläche 14 zu erkennen.

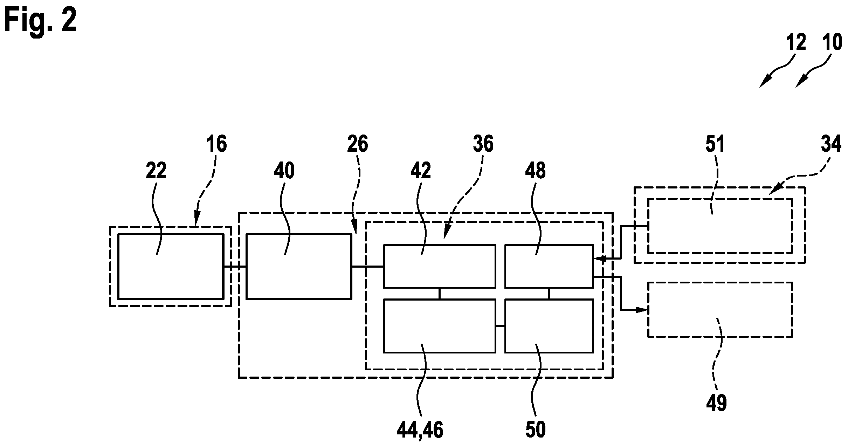

In Figur 2 ist eine Prinzipskizze der Regenerkennungsvorrichtung 12 gezeigt, wobei insbesondere Signalwege, Funktionen und Bauteile der Regenerkennungsvorrichtung 12 dargestellt sind. Die Auswerteeinheit 26 weist einen Digitalwandler 40 auf, der dazu vorgesehen ist, die kapazitiven Signale des Sensorelements 22, insbesondere die Kapazitätskenngröße, in einen digitalen Datenstrom umzuwandeln und an den Mikrocontroller 36 zu übertragen. Insbesondere ist der Digitalwandler 40 dazu vorgesehen, die Kapazitätskenngröße zumindest im Wesentlichen kontinuierlich abzurufen, insbesondere mit einer Auslesefrequenz von zumindest im Wesentlichen 38 Hz. Die Auswerteeinheit 26, insbesondere der Mikrocontroller 36, ist dazu eingerichtet (siehe Funktion 42), aus der als digitaler Datenstrom übertragenen Kapazitätskenngröße das differentielle Signal zu generieren. Vorzugsweise umfasst der Digitalwandler 40 zumindest einen Schwingkreis (in den Figuren nicht gezeigt), wobei der Digitalwandler 40 dazu vorgesehen ist, die Kapazitätskenngröße über eine Erfassung einer Resonanzfrequenz des Schwingkreises in den digitalen Datenstrom umzuwandeln. Insbesondere ist die Resonanzfrequenz des Schwingkreises abhängig von der Kapazitätskenngröße des Sensorelements 22. Bevorzugt wird zur Umwandlung der Kapazitätskenngröße des Sensorelements 22 in den digitalen Datenstrom die Resonanzfrequenz des Schwingkreises oder eine dazu proportionale andere Kenngröße des Digitalwandlers 40, insbesondere des Schwingkreises, gemessen, welche sich insbesondere bei einer Änderung der Kapazitätskenngröße ändert. Insbesondere beträgt eine nominale Oszillationsfrequenz des Schwingkreises zumindest im Wesentlichen 6,530 MHz. Es sind aber auch andere Ausgestaltungen des Digitalwandlers 40 denkbar.

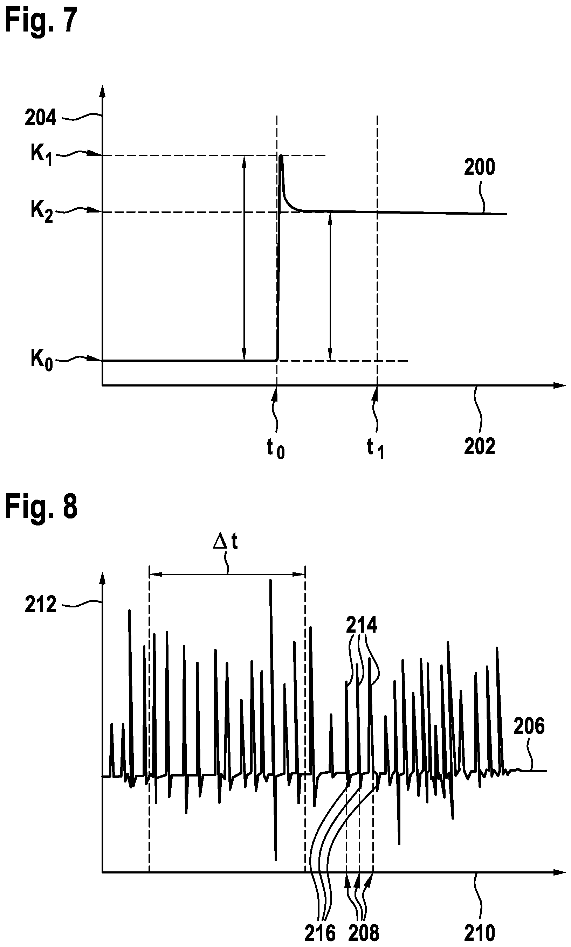

Die Symmetriekenngröße ist als ein Verhältnis einer positiven Gewichtungskenngröße des differentiellen Signals und einer negativen Gewichtungskenngröße des differentiellen Signals ausgebildet (siehe auch Figuren 7 und 8), wobei die Auswerteeinheit 26 dazu eingerichtet ist, in Abhängigkeit von einer Überschreitung eines Grenzwerts oder eines Grenzbereichs der Symmetriekenngröße einen Regentropfen auf der Oberfläche 14 zu erkennen. Vorzugsweise ist die positive Gewichtungskenngröße als ein, insbesondere absolutes, Maximum des differentiellen Signals innerhalb eines ausgewerteten Zeitintervalls, als ein positiver Anteil eines Integrals des differentiellen Signals über das ausgewertete Zeitintervall oder als eine Summe von lokalen Maxima innerhalb des ausgewerteten Zeitintervalls ausgebildet. Bevorzugt ist die negative Gewichtungskenngröße als ein, insbesondere absolutes, Minimum des differentiellen Signals innerhalb des ausgewerteten Zeitintervalls, als ein negativer Anteil eines Integrals des differentiellen Signals über das ausgewertete Zeitintervall oder als eine Summe von lokalen Minima innerhalb des ausgewertete Zeitintervalls ausgebildet. Die Auswerteeinheit 26 umfasst einen Algorithmus 44 zu einem Erkennen von Regentropfen auf der Oberfläche 14 und/oder zu einem Erkennen eines Regenzustands an der Oberfläche 14 mittels über das Sensorelement 22 erfassten Signalen. Insbesondere beschreibt der Regenzustand gemäß einem vorgegebenen Grenzwert für eine Anzahl an mittels der Auswerteeinheit 26 erkannten Regentropfen auf der Oberfläche 14 innerhalb eines vorgegebenen Zeitraums, ob es regnet oder nicht. Die Auswerteeinheit 26, insbesondere der Algorithmus 44, ist dazu eingerichtet, zum Erkennen von Regentropfen auf der Oberfläche 14 das Verhältnis der positiven Gewichtungskenngröße des differentiellen Signals und der negativen Gewichtungskenngröße des differentiellen Signals mit dem zumindest einen Grenzwert oder dem Grenzbereich der Symmetriekenngröße zu vergleichen. Insbesondere ist der Grenzwert oder der Grenzbereich der Symmetriekenngröße in der Auswerteeinheit 26 hinterlegt. Es ist denkbar, dass der Grenzwert oder der Grenzbereich der Symmetriekenngröße bei einer Herstellung oder einer Wartung der Regenerkennungsvorrichtung 12 vorgegeben wird und/oder mittels der Auswerteeinheit 26, insbesondere dem Algorithmus 44 dynamisch, beispielsweise mittels eines maschinellen Lernverfahrens, angepasst wird. Es ist auch denkbar, dass der Grenzwert oder der Grenzbereich der Symmetriekenngröße über die Bedienerschnittstelle 28 durch einen Benutzer einstellbar ist. In einer bevorzugten Ausgestaltung beträgt der Grenzwert der als Verhältnis der positiven Gewichtungskenngröße und der negativen Gewichtungskenngröße ausgebildeten Symmetriekenngröße mindestens 2, vorzugsweise mindestens 3 und bevorzugt mindestens 4, wobei insbesondere das ausgewertete Zeitintervall mindestens 2 s, vorzugsweise mindestens 3 s und bevorzugt mindestens 4 s und/oder höchstens 10 s, vorzugsweise höchstens 8 s und bevorzugt höchstens 5 s, beträgt. Alternativ oder zusätzlich ist die Auswerteeinheit 26 dazu vorgesehen, bei einer Erkennung von mindestens 2, vorzugsweise mindestens 3 und bevorzugt mindestens 4 Regentropfen auf der Oberfläche 14 innerhalb eines Zeitintervalls von mindestens 2 s, vorzugsweise mindestens 3 s und bevorzugt mindestens 4 s und/oder höchstens 10 s, vorzugsweise höchstens 8 s und bevorzugt höchstens 5 s, einen Regenzustand zu erkennen.

Die Auswerteeinheit 26, insbesondere der Algorithmus 44, ist dazu eingerichtet (siehe Funktion 46), das differentielle Signal in Zeitintervallen, insbesondere kontinuierlich, stückweise auszuwerten und für jedes ausgewertete Zeitintervall genau einen booleschen Wert eines Regenzustands an der Oberfläche 14 auszugeben. Insbesondere gibt ein boolescher Wert des Regenzustands einen Regenzustand an der Oberfläche 14 an, wobei ein anderer boolescher Wert des Regenzustands eine Abwesenheit des Regenzustands an der Oberfläche 14 angibt. Vorzugsweise betragen die Zeitintervalle jeweils mindestens 2 s, vorzugsweise mindestens 3 s und bevorzugt mindestens 4 s und/oder höchstens 10 s, vorzugsweise höchstens 8 s und bevorzugt höchstens 5 s. Bevorzugt sind die Zeitintervalle hintereinander angeordnet, wobei insbesondere die Auswerteeinheit 26 dazu eingerichtet ist, das kontinuierliche differentielle Signal in die Zeitintervalle aufzuteilen. Alternativ ist auch denkbar, dass die Auswerteeinheit 26 dazu vorgesehen ist, das differentielle Signal in periodischen Abständen über jeweils ein Zeitintervall auszuwerten.

Die Auswerteeinheit 26 ist dazu eingerichtet (siehe Funktion 48), in Abhängigkeit von der Erkennung von Regentropfen auf der Oberfläche 14 zumindest ein Ausgabesignal 49, insbesondere den booleschen Wert des Regenzustands an der Oberfläche 14, auszugeben, wobei die Auswerteeinheit 26 dazu eingerichtet ist (siehe Funktion 50), eine Ausgabe des Ausgabesignals 49 und/oder eine Änderung des Ausgabesignals 49 zeitlich zu limitieren. Die Auswerteeinheit 26 ist dazu eingerichtet (siehe Funktion 50), eine Anzahl an ausgegebenen Werten, insbesondere den booleschen Werten, des Regenzustands und/oder an Ausgabevorgängen des Regenzustands zeitlich zu begrenzen. Bevorzugt ist die Auswerteeinheit 26 dazu eingerichtet einen, insbesondere booleschen, ausgegebenen Wert des Regenzustands zumindest über ein Zeitintervall zu speichern und erst nach Ablauf dieses Zeitintervalls einen weiteren Wert des Regenzustands auszugeben, wobei das Zeitintervall mindestens 2 s, vorzugsweise mindestens 3 s und bevorzugt mindestens 4 s und/oder höchstens 1 min, vorzugsweise höchstens 30 s und bevorzugt höchstens 10 s, beträgt. Vorzugsweise umfasst das Ausgabesignal 49 zumindest den durch die Auswerteeinheit 26 ermittelten booleschen Wert. Die Auswerteeinheit 26 ist dazu eingerichtet, das Ausgabesignal 49 an das Gartengerät 10 und/oder die externe Einheit 32 auszugeben. Insbesondere ist die Kommunikationseinheit 30 dazu vorgesehen, das Ausgabesignal 49 an die externe Einheit 32 zu übertragen. Die Auswerteeinheit 26 ist dazu eingerichtet, eine Anzahl an erkannten und/oder identifizierten Regentropfen für jedes ausgewertete Zeitintervall zu ermitteln. Insbesondere ist die Auswerteeinheit 26 dazu eingerichtet, bei einer Überschreitung eines Grenzwerts der Anzahl an innerhalb des Zeitintervalls erkannten und/oder identifizierten Regentropfen den Regenzustand an der Oberfläche 14 zu erkennen. Bevorzugt ist die Auswerteeinheit 26 dazu eingerichtet, bei einem Erkennen des Regenzustands an der Oberfläche 14, ein den booleschen Wert des Regenzustands umfassendes Ausgabesignal 49 auszugeben.

Die Steuer- und/oder Regeleinheit 34, insbesondere alternativ eine Steuer- und/oder Regeleinheit der Regenerkennungsvorrichtung 12, ist dazu eingerichtet, zumindest einen Auswertungsparameter der Auswerteeinheit 26, insbesondere des Mikrocontrollers 36 und/oder des Algorithmus 44, in Abhängigkeit von einer, insbesondere über die Auswerteeinheit 26, automatisch ermittelten und/oder vorgegebenen Sensitivitätskenngröße 51 anzupassen. Insbesondere ist die Steuer- und/oder Regeleinheit 34 dazu eingerichtet, die Sensitivitätskenngröße 51 an die Auswerteeinheit 26 zu übertragen, wobei die Auswerteeinheit 26, insbesondere der Mikrocontroller 36, dazu eingerichtet ist, den Auswertungsparameter gemäß einem, einem übertragenen Wert der Sensitivitätskenngröße 51 zugeordneten Wert des Auswertungsparameters anzupassen. Es ist auch denkbar, dass die Sensitivitätskenngröße 51 direkt über die Bedienerschnittstelle 28 oder eine Bedienerschnittstelle der Regenerkennungsvorrichtung 12 an die Auswerteeinheit 26, insbesondere den Mikrocontroller 36 übertragen wird.

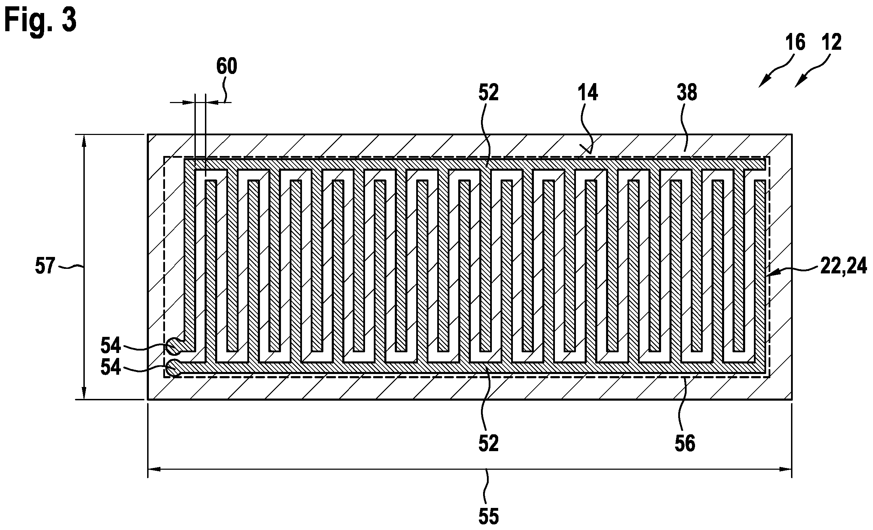

In Figur 3 ist schematisch eine geschnittene Draufsicht der Sensoreinheit 16 gezeigt, wobei insbesondere die Sensoreinheit 16 durch das Sensorelement 22 entlang einer Haupterstreckungsebene des Sensorelements 22 geschnitten ist. Die Sensoreinheit 16 ist als eine zumindest im Wesentlichen biegeschlaffe flexible Membran ausgebildet, welche zumindest elektrisch mit der Auswerteeinheit 26 verbunden ist. Die Sensoreinheit 16 umfasst zwei, insbesondere plattenförmige flexible Isolierelemente 38, wobei insbesondere das Elektrodenpaar 24 zwischen den zwei Isolierelementen 38 angeordnet ist. Die Isolierelemente 38 sind aus einem, insbesondere zumindest im Wesentlichen biegeschlaffen, flexiblen Material, wie beispielsweise einem Kunststoff, Gummi, o. dgl., ausgebildet. Das Elektrodenpaar 24 ist zumindest größtenteils, insbesondere zumindest im Wesentlichen vollständig, innerhalb der zwei Isolierelemente 38 angeordnet, beispielsweise eingegossen und/oder eingebettet. Das Sensorelement 22 ist derart ausgebildet, dass eine Änderung eines minimalen Abstands von zwei Elektroden 52 des Elektrodenpaars 24 bei einem Verformen, insbesondere Biegen, des Sensorelements 22 und/oder der Isolierelemente 38 zumindest im Wesentlichen verhindert wird. Insbesondere ist das Elektrodenpaar 24 über einen Siebdruck auf ein Isolierelement 38 der zwei Isolierelemente 38 aufgebracht, wobei insbesondere das Elektrodenpaar 24 zwischen dem Isolierelement 38 und dem anderen Isolierelement 38 der zwei Isolierelemente 38 angeordnet ist. Insbesondere ist das Elektrodenpaar 24 mit Ausnahme von zwei elektrischen Kontakten 54 des Elektrodenpaars 24 zu einer Verbindung mit der Auswerteeinheit 26 zumindest im Wesentlichen vollständig von dem Isolierelement 38 und dem weiteren Isolierelement 38 umschlossen. Das Sensorelement 22, insbesondere das Elektrodenpaar 24, und die Isolierelemente 38 sind einstückig ausgebildet. Es sind aber auch Ausgestaltungen der Sensoreinheit 16 mit nur einem Isolierelement 38 denkbar, welches die Oberfläche 14 ausbildet und/oder zwischen der Oberfläche 14 und dem Elektrodenpaar 24 angeordnet ist. Insbesondere ist das Elektrodenpaar 24 an einer der Oberfläche 14 abgewandten Seite des Isolierelements 38 an dem Isolierelement 38 angeordnet.

Das kapazitive Sensorelement 22 bildet genau ein Elektrodenpaar 24 aus, welches zumindest elektrisch mit der Auswerteeinheit 26 verbunden ist, wobei das Elektrodenpaar 24 eine maximale Erfassungsfläche 56 aufspannt, die mindestens 12 cm², vorzugsweise mindestens 16 cm² und bevorzugt mindestens 20 cm², beträgt. Insbesondere beträgt die maximale Erfassungsfläche 56 des, insbesondere in der Figur 3 gezeigten, Sensorelements 22, insbesondere des Elektrodenpaars 24, zumindest im Wesentlichen 16,12 cm². Insbesondere beträgt die maximale Erfassungsfläche 56 des Sensorelements 22, insbesondere des Elektrodenpaars 24, höchstens 100 cm², vorzugsweise höchstens 50 cm² und bevorzugt höchstens 30 cm². Die Oberfläche 14 der Sensoreinheit 16, insbesondere des Isolierelements 38, entspricht zumindest der maximalen Erfassungsfläche 56 des Sensorelements 22, insbesondere des Elektrodenpaares 24. Die maximale Erfassungsfläche 56 des Sensorelements 22, insbesondere des Elektrodenpaars 24, ist zumindest im Wesentlichen parallel zur Oberfläche 14 angeordnet. Die maximale Erfassungsfläche 56 des Sensorelements 22, insbesondere des Elektrodenpaars 24, ist insbesondere als eine Fläche ausgebildet, welche das Elektrodenpaar 24 gerade noch vollständig einschließt. Ein minimaler Abstand 58 zwischen den zwei Elektroden 52 des Elektrodenpaars 24 ist innerhalb der maximalen Erfassungsfläche 56 des Sensorelements 22, insbesondere des Elektrodenpaars 24, angeordnet. Das Sensorelement 22, insbesondere das Elektrodenpaar 24, weist in einem Grundzustand des Sensorelements 22, insbesondere in Abwesenheit von einem festen Objekt und/oder Regentropfen auf der Oberfläche 14 und/oder lediglich Luft in einem Nahbereich der Oberfläche 14, eine Kapazitätskenngröße von mindestens 5 pF, vorzugsweise mindestens 10 pF und bevorzugt mindestens 12 pF, auf. Bevorzugt entspricht die Kapazitätskenngröße des Sensorelements 22, insbesondere des Elektrodenpaars 24, im Grundzustand einem Wert von zumindest im Wesentlichen 12,8 pF. Insbesondere beträgt die Kapazitätskenngröße des Sensorelements 22, insbesondere des Elektrodenpaars 24, im Grundzustand höchstens 50 pF, vorzugsweise höchstens 30 pF und bevorzugt höchstens 20 pF. Insbesondere ist die Sensoreinheit 16, insbesondere das Sensorelement 22 und/oder das Isolierelement 38, derart ausgebildet, dass sich ein Wert der Kapazitätskenngröße des Sensorelements 22 bei einem Auftreffen eines Regentropfens auf der Oberfläche 14 um einen Wert aus einem Wertebereich von 100 fF bis 1000 fF, vorzugsweise von 200 fF bis 800 fF und bevorzugt von 300 fF bis 500 fF, ändert.

Die zwei Elektroden 52 des Elektrodenpaars 24 sind beabstandet voneinander ausgebildet. Der minimale Abstand 60 der zwei Elektroden 52 beträgt höchstens 1,5 mm, vorzugsweise höchstens 1,2 mm und bevorzugt höchstens 1 mm. Insbesondere beträgt der minimale Abstand 60 der zwei, insbesondere in der Figur 3 gezeigten, Elektroden 52 zumindest im Wesentlichen 1 mm. Insbesondere beträgt der minimale Abstand 60 der zwei Elektroden 52 mindestens 0,2 mm, vorzugsweise mindestens 0,4 mm und bevorzugt mindestens 0,5 mm. Insbesondere erstrecken sich die zwei Elektroden 52 in der Haupterstreckungsebene des Sensorelements 22, die zumindest im Wesentlichen parallel zur Oberfläche 14 ausgerichtet ist. Insbesondere ist die Haupterstreckungsebene des Sensorelements 22 in Figur 3 zumindest im Wesentlichen parallel zur Bildebene angeordnet und insbesondere in den Figuren nicht gezeigt. Die Oberfläche 14 ist ebenflächig ausgebildet und zumindest im Wesentlichen parallel zur Haupterstreckungsebene des Sensorelements 22 angeordnet. Es ist aber auch denkbar, dass die Oberfläche 14 und/oder das Sensorelement 22, insbesondere die zwei Elektroden 52, und/oder die zwei Isolierelemente 38 gebogen ausgebildet sind, wobei insbesondere die Oberfläche 14 und das Sensorelement 22, insbesondere die zwei Elektroden 52, eine zumindest im Wesentlichen identische Grundform, insbesondere Biegung, aufweisen. Bevorzugt ist die maximale Dicke des Sensorelements 22, insbesondere der zwei Elektroden 52, zumindest im Wesentlichen senkrecht zur Haupterstreckungsebene des Sensorelements 22 ausgerichtet. Das Sensorelement 22, insbesondere die zwei Elektroden 52, ist in einem unbelasteten Zustand zumindest im Wesentlichen plattenförmig ausgebildet. Es ist aber auch denkbar, dass das Sensorelement 22, insbesondere die zwei Elektroden 52, im unbelasteten Zustand in zumindest einer, insbesondere zumindest im Wesentlichen senkrecht zur Haupterstreckungsebene des Sensorelements 22 ausgerichteten, Schnittebene eine kreisringsegmentförmige und/oder gebogene Grundform aufweist.

Die Sensoreinheit 16, insbesondere das Sensorelement 22 und die Isolierelemente 38, weisen eine rechteckige Grundform auf. Es sind aber auch andere Ausgestaltungen der Sensoreinheit 16 denkbar, beispielsweise mit einer runden oder quadratischen Grundform. Vorzugsweise weist die Sensoreinheit 16, insbesondere das Sensorelement 22 und/oder die Isolierelemente 38, eine maximale Längserstreckung 55 von mindestens 4 cm, vorzugsweise mindestens 5 cm und bevorzugt mindestens 6 cm, auf. Insbesondere beträgt die maximale Längserstreckung 55 der, insbesondere in der Figur 3 gezeigten, Sensoreinheit 16, insbesondere des Sensorelements 22 und/oder der Isolierelemente 38, zumindest im Wesentlichen 6,2 cm. Bevorzugt weist die Sensoreinheit 16, insbesondere das Sensorelement 22 und/oder die Isolierelemente 38, eine maximale Quererstreckung 57 von mindestens 1,5 cm, vorzugsweise mindestens 2 cm und bevorzugt mindestens 2,5 cm, auf. Insbesondere beträgt die maximale Quererstreckung 57 der, insbesondere in der Figur 3 gezeigten, Sensoreinheit 16, insbesondere des Sensorelements 22 und/oder der Isolierelemente 38, zumindest im Wesentlichen 2,6 cm. Insbesondere sind die maximale Längserstreckung 55 und die maximale Quererstreckung 57 der Sensoreinheit 16, insbesondere des Sensorelements 22 und/oder der Isolierelemente 38, zumindest im Wesentlichen senkrecht zueinander angeordnet. Bevorzugt ist die maximale Längserstreckung 55 der Sensoreinheit 16, insbesondere des Sensorelements 22 und/oder der Isolierelemente 38, als eine längste Kante eines gedachten Quaders ausgebildet, welcher die Sensoreinheit 16, insbesondere das Sensorelements 22 und/oder die Isolierelemente 38, gerade noch vollständig umschließt. Insbesondere sind die maximale Längserstreckung 55 und/oder die maximale Quererstreckung 57 der Sensoreinheit 16, insbesondere des Sensorelements 22 und/oder der Isolierelemente 38, in der Haupterstreckungsebene der Sensoreinheit 16 betrachtet als Seitenkanten des gedachten Quaders ausgebildet, welcher die Sensoreinheit 16, insbesondere das Sensorelements 22 und/oder die Isolierelemente 38, gerade noch vollständig umschließt.

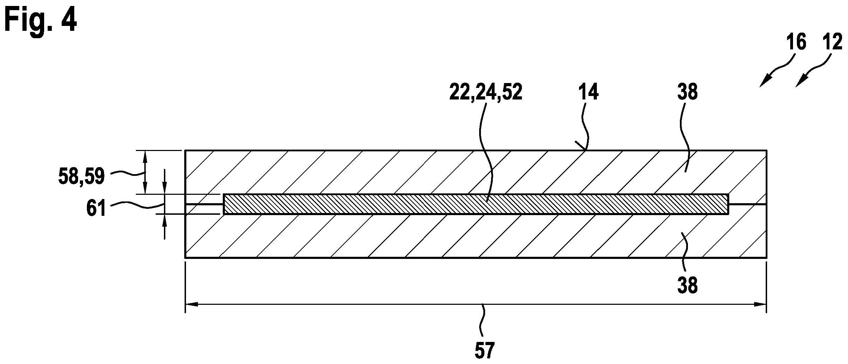

In Figur 4 ist schematisch eine geschnittene Seitenansicht der Sensoreinheit 16 gezeigt, wobei insbesondere die Sensoreinheit 16 zumindest im Wesentlichen senkrecht zur Haupterstreckungsebene des Sensorelements 22 geschnitten ist. Ein minimaler Abstand 58 der Oberfläche 14 und der zwei Elektroden 52 beträgt höchstens 0,8 mm, vorzugsweise höchstens 0,5 mm und bevorzugt höchstens 0,38 mm. Insbesondere entspricht der minimale Abstand 58 der Oberfläche 14 und der zwei Elektroden 52 zumindest im Wesentlichen 0,35 mm. Insbesondere entspricht der minimale Abstand 58 der Oberfläche 14 und der zwei Elektroden 52 jeweils zumindest im Wesentlichen einer Dicke 59 eines der zwei Isolierelemente 38, welches insbesondere zwischen den zwei Elektroden 52 und der Oberfläche 14 angeordnet ist. Insbesondere beträgt der minimale Abstand 58 der Oberfläche 14 und der zwei Elektroden 52 mindestens 0,05 mm, vorzugsweise mindestens 0,15 mm und bevorzugt mindestens 0,3 mm. Bevorzugt ist der minimale Abstand 58 der Oberfläche 14 und der zwei Elektroden 52 über einen Bereich, welcher sich zwischen der Oberfläche 14 und den zwei Elektroden 52 erstreckt, zumindest im Wesentlichen konstant ausgebildet. Die Sensoreinheit 16 ist derart ausgebildet, dass ein Objekt, insbesondere ein Regentropfen, das sich im Nahbereich der Oberfläche 14 bewegt oder angeordnet ist und/oder die Oberfläche 14 berührt, einen Wert der Kapazitätskenngröße des Sensorelements 22, insbesondere des Elektrodenpaars 24, beeinflusst und/oder ändert. Das Sensorelement 22, insbesondere die zwei Elektroden 52, weisen eine maximale Dicke 61 von höchstens 3 mm, vorzugsweise höchstens 2,5 mm und bevorzugt höchstens 2 mm, auf, wobei insbesondere die maximale Dicke 61 des Sensorelements 22, insbesondere der zwei Elektroden 52, zumindest im Wesentlichen senkrecht zur Haupterstreckungsebene des Sensorelements 22 und/oder zur maximalen Erfassungsfläche 56 des Sensorelements 22, insbesondere des Elektrodenpaars 24, ausgerichtet ist.

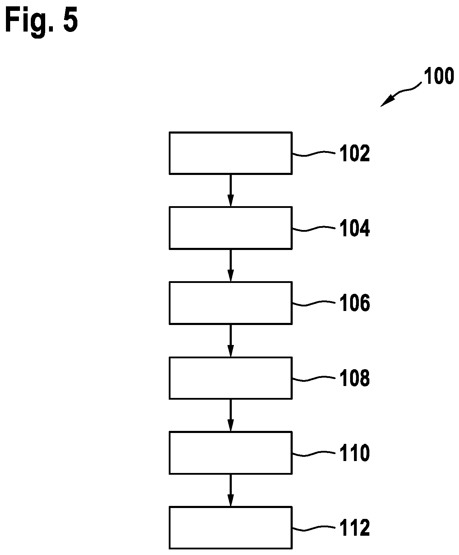

In Figur 5 ist ein beispielhafter Ablauf eines Verfahrens 100 zu einer Erfassung von Regentropfen auf der Oberfläche 14 mittels der Regenerkennungsvorrichtung 12 gezeigt. In einem Verfahrensschritt 102 des Verfahrens 100 wird mittels des kapazitiven Sensorelements 22 der Regenerkennungsvorrichtung 12 die Kapazitätskenngröße erfasst. In einem weiteren Verfahrensschritt 104 des Verfahrens 100 wird mittels der Auswerteeinheit 26 aus der erfassten Kapazitätskenngröße das differentielle Signal generiert. In einem weiteren Verfahrensschritt 106 des Verfahrens 100 wird, insbesondere vor einer Auswertung zur Erkennung von Regentropfen auf der Oberfläche 14, das differentielle Signal mittels der Auswerteeinheit 26 nach Störsignalen gefiltert. Alternativ ist aber auch denkbar, dass die Kapazitätskenngröße mittels der Auswerteeinheit 26 nach Störsignalen gefiltert wird, vorzugsweise vor einer Generierung des differentiellen Signals. In einem weiteren Verfahrensschritt 108 des Verfahrens 100 erfolgt mittels der Auswerteeinheit 26 der Regenerkennungsvorrichtung 12 in Abhängigkeit von dem differentiellen Signal des Sensorelements 22 die Erkennung von Regentropfen auf der Oberfläche 14. In einem Verfahrensschritt des Verfahrens 100, insbesondere dem Verfahrensschritt 108, erfolgt die Erkennung von Regentropfen auf der Oberfläche 14 mittels der Auswerteeinheit 26 in Abhängigkeit von der Symmetriekenngröße des differentiellen Signals, insbesondere gegenüber einem Nullpunkt. Vorzugsweise wird in einem Verfahrensschritt des Verfahrens 100, insbesondere dem Verfahrensschritt 108, der Algorithmus 44 mittels der Auswerteeinheit 26 zur Erkennung von Regentropfen auf der Oberfläche 14 und/oder des Regenzustands an der Oberfläche 14 ausgeführt. In einem Verfahrensschritt des Verfahrens 100, insbesondere dem Verfahrensschritt 108, wird das kontinuierliche differentielle Signal mittels der Auswerteeinheit 26 zur Erkennung von Regentropfen auf der Oberfläche 14 in Abhängigkeit von zumindest einer Gewichtungskenngröße des differentiellen Signals über ein vorgegebenes oder ein dynamisches Zeitintervall ausgewertet. In zumindest einem weiteren Verfahrensschritt 110 des Verfahrens 100 wird mittels der Auswerteeinheit 26 für jedes ausgewertete Zeitintervall genau ein boolescher Wert eines Regenzustands an der Oberfläche 14 ausgegeben. Insbesondere wird mittels der Auswerteeinheit 26 eine Anzahl an erkannten und/oder identifizierten Regentropfen für jedes ausgewertete Zeitintervall ermittelt. Bevorzugt wird mittels der Auswerteeinheit 26 bei einer Überschreitung des Grenzwerts der Anzahl an innerhalb des Zeitintervalls erkannten und/oder identifizierten Regentropfen der Regenzustand an der Oberfläche 14 erkannt. Vorzugsweise wird mittels der Auswerteeinheit 26, bei dem Erkennen des Regenzustands an der Oberfläche 14, ein den booleschen Wert des Regenzustands umfassendes Ausgabesignal ausgegeben. Insbesondere wird mittels der Auswerteeinheit 26 eine Ausgabe des Ausgabesignals und/oder eine Änderung des Ausgabesignals zeitlich limitiert. In einem weiteren Verfahrensschritt 112 des Verfahrens 100 wird mittels der Steuer- und/oder Regeleinheit 34 zumindest ein Auswertungsparameter der Auswerteeinheit 26 in Abhängigkeit von einer, insbesondere über die Auswerteeinheit 26, automatisch ermittelten und/oder vorgegebenen Sensitivitätskenngröße angepasst. Insbesondere wird die Sensitivitätskenngröße beispielsweise mittels der Bedienerschnittstelle 28 und/oder der Kommunikationseinheit 30 von einem Benutzer oder der externen Einheit 32 an die Auswerteeinheit 26 übertragen.

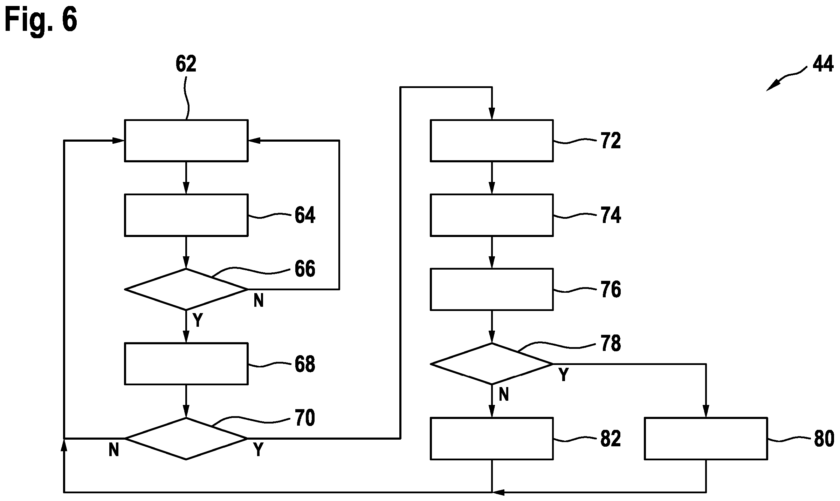

In Figur 6 ist ein schematischer Ablauf des Algorithmus 44 der Auswerteeinheit 26, insbesondere des Mikrocontrollers 36, gezeigt. Insbesondere ist der Algorithmus 44 mittels der Auswerteeinheit 26, insbesondere des Mikrocontrollers 36, ausführbar. Bevorzugt werden alle Schritte 62, 64, 66, 68, 70, 72, 74, 76, 78, 80, 82 des Algorithmus 44, insbesondere entsprechend dem in Figur 6 gezeigten und im Folgenden beschriebenen Ablauf des Algorithmus 44, mittels der Auswerteeinheit 26, insbesondere des Mikrocontrollers 36, ausgeführt. In einem ersten Schritt 62 des Algorithmus 44 werden Werte der Kapazitätskenngröße von der Sensoreinheit 16 eingelesen. In einem weiteren Schritt 64 des Algorithmus 44 wird aus den eingelesenen Werten der Kapazitätskenngröße das differentielle Signal generiert. In einem weiteren Schritt 66 des Algorithmus 44 wird ermittelt, ob innerhalb eines betrachteten und/oder ausgewerteten Zeitintervalls bereits ein Signalpeak erfasst wurde. Ist dies nicht der Fall, werden weitere Werte der Kapazitätskenngröße eingelesen. Wurde bereits ein Signalpeak erfasst, wird in einem weiteren Schritt 68 des Algorithmus 44 der Signalpeak hinterlegt und bezüglich eines Maximums und/oder eines Integrals des Signalpeaks ausgewertet, wobei insbesondere das Maximum und/oder das Integral des Signalpeaks gespeichert wird. In einem weiteren Schritt 70 des Algorithmus 44 wird geprüft, ob ein Ende eines laufenden Zeitintervalls zur Erkennung von Regentropfen erreicht ist. Falls dies nicht der Fall ist, werden weitere Werte der Kapazitätskenngröße eingelesen. Ist das Ende des laufenden Zeitintervalls erreicht, wird in einem weiteren Schritt 72 des Algorithmus 44 die negative Gewichtungskenngröße des differentiellen Signals für das Zeitintervall ermittelt, wobei insbesondere alle negativen Signalpeaks, insbesondere die Maxima und/oder die Integrale der negativen Signalpeaks, summiert werden. In einem weiteren Schritt 74 des Algorithmus 44 wird die positive Gewichtungskenngröße des differentiellen Signals für das Zeitintervall ermittelt, wobei insbesondere alle positiven Signalpeaks, insbesondere die Maxima und/oder die Integrale der positiven Signalpeaks, summiert werden. In einem weiteren Schritt 76 des Algorithmus 44 wird das Verhältnis der positiven Gewichtungskenngröße und der negativen Gewichtungskenngröße für das Zeitintervall berechnet. In einem weiteren Schritt 78 des Algorithmus 44 wird das berechnete Verhältnis der positiven Gewichtungskenngröße und der negativen Gewichtungskenngröße für das Zeitintervall mit dem Grenzwert oder dem Grenzbereich der Symmetriekenngröße verglichen. Wird der Grenzwert oder der Grenzbereich der Symmetriekenngröße von dem berechneten Verhältnis der positiven Gewichtungskenngröße und der negativen Gewichtungskenngröße für das Zeitintervall überschritten, wird in einem weiteren Schritt 80 des Algorithmus ein als boolescher Wert ausgebildetes Ausgabesignal ausgegeben, wobei insbesondere der boolesche Wert einen Regenzustand an der Oberfläche 14 angibt. Überschreitet das berechnete Verhältnis der positiven Gewichtungskenngröße und der negativen Gewichtungskenngröße für das Zeitintervall den Grenzwert oder den Grenzbereich der Symmetriekenngröße nicht, wird in einem weiteren Schritt 82 des Algorithmus 44 ein als anderer boolescher Wert ausgebildetes Ausgabesignal ausgeben, wobei insbesondere der andere boolesche Wert eine Abwesenheit des Regenzustands an der Oberfläche 14 angibt. Nach einer Ausgabe des Ausgabesignals wird ein Einlesen von Werten der Kapazitätskenngröße eines weiteren, insbesondere auf das Zeitintervall folgenden, Zeitintervalls gestartet (siehe erster Schritt 62 des Algorithmus 44).

In Figur 7 ist eine beispielhafte Messung eines zeitlichen Verlaufs 200 der Kapazitätskenngröße des Sensorelements 22 während eines Auftreffens eines Regentropfens auf der Oberfläche 14 gezeigt. Eine Abszisse 202 stellt die Zeit dar. Eine Ordinate 204 stellt die Kapazitätskenngröße in Abhängigkeit der Zeit dar. Beim Auftreffen des Regentropfens zum Zeitpunkt t₀ wird die Kapazitätskenngröße des Sensorelements 22 sprunghaft von einem Grundwert k₀ auf einen Wert k₁ erhöht. Die Kapazitätskenngröße sinkt dann bis zu einem Zeitpunkt t₁ wieder auf einen Wert k₂ ab, wobei insbesondere der Wert k₂ größer ist als der Grundwert k₀. Bevorzugt wird der, insbesondere gegenüber dem Grundwert k₀ erhöhte, Wert k₂ der Kapazitätskenngröße durch eine sich auf der Oberfläche 14 verteilende Wassermenge des Regentropfens erzeugt. Ein aus dem, insbesondere in Figur 7 gezeigten, zeitlichen Verlauf 200 der Kapazitätskenngröße generiertes differentielles Signal weist einen positives Signalpeak und einen negativen Signalpeak auf (siehe Figur 8), wobei insbesondere ein Betrag eines Maximums des positiven Signalpeaks größer ist als ein Betrag eines Minimums des negativen Signalpeaks. Insbesondere ist ein Wert eines Integrals über den positiven Signalpeak größer als ein Wert eines Integrals über den negativen Signalpeak. Vorzugsweise weist ein zeitlicher Verlauf 206 des aus dem, insbesondere in Figur 7 gezeigten, zeitlichen Verlauf 200 der Kapazitätskenngröße generierten differentiellen Signals eine Asymmetrie gegenüber dem Nullpunkt auf (siehe Figur 8). Insbesondere ist die Auswerteeinheit 26 dazu eingerichtet, bei einer Auswertung des zeitlichen Verlaufs 206 des aus dem, insbesondere in Figur 7 gezeigten, zeitlichen Verlauf 200 der Kapazitätskenngröße generierten differentiellen Signals einen Regentropfen auf der Oberfläche 14 zu erkennen und/oder zu identifizieren.

In Figur 8 ist eine beispielhafte Messung eines zeitlichen Verlaufs 206 des differentiellen Signals des Sensorelements 22 über ein Zeitintervall gezeigt, wobei eine Vielzahl von Regentropfen innerhalb des Zeitintervalls auf die Oberfläche 14 getroffen ist. Insbesondere ist jeweils ein Auftreffen der Regentropfen zu Zeitpunkten 208 im zeitlichen Verlauf 206 des differentiellen Signals zu sehen. Eine Abszisse 210 stellt die Zeit dar. Eine Ordinate 212 stellt das differentielle Signal in Abhängigkeit der Zeit dar. Der zeitliche Verlauf 206 des differentiellen Signals umfasst eine Vielzahl von positiven Signalpeaks 214 und eine Vielzahl von negativen Signalpeaks 216, die jeweils paarweise hintereinander angeordnet sind. Insbesondere entspricht eine Anzahl der positiven Signalpeaks 214 und eine Anzahl der negativen Signalpeaks 216 einer Anzahl von auf die Oberfläche aufgetroffenen Regentropfen im Zeitintervall. Jeweils ein positiver Signalpeak 214 und jeweils ein direkt auf den positiven Signalpeak 214 folgender negativer Signalpeak 216, welcher insbesondere kleiner ist als der positive Signalpeak 214, wird durch einen auf der Oberfläche 14 auftreffenden Regentropfen erzeugt, insbesondere durch einen, dem in der Figur 7 gezeigten zeitlichen Verlauf 200 ähnlichen zeitlichen Verlauf der Kapazitätskenngröße. Beispielsweise wird, falls innerhalb eines Zeitintervalls Δt mittels der Auswerteeinheit 26 mehr als fünf Regentropfen identifiziert und/oder erkannt werden, ein Regenzustand an der Oberfläche 14 erkannt. Es ist aber auch ein anderer, insbesondere von fünf verschieden ausgebildeter, Grenzwert für die Erkennung und/oder Identifikation des Regenzustands an der Oberfläche 14 denkbar. Insbesondere würde ein von einem Regentropfen verschiedener Gegenstand, beispielsweise ein Finger oder ein Ast, im differentiellen Signal jeweils einen positiven Signalpeak und einen negativen Signalpeak erzeugen, welche jedoch zumindest im Wesentlichen ein betragsgleiches Maximum beziehungsweise Minimum oder zumindest im Wesentlichen identische Werte für ein Integral über die Signalpeaks aufweisen. Vorzugsweise ist die Auswerteeinheit 26 dazu eingerichtet, mittels der Symmetriekenngröße Regentropfen auf der Oberfläche 14 von, von einem Regentropfen verschiedenen Gegenständen, welche die Oberfläche 14 berühren und/oder an der Oberfläche 14 angeordnet sind, zu unterscheiden.

## Patentansprüche

1. Regenerkennungsvorrichtung zu einer Erfassung von Regentropfen auf einer Oberfläche (14), mit zumindest einer Sensoreinheit (16), die zumindest ein kapazitives Sensorelement (22) umfasst, wobei das Sensorelement (22) derart ausgebildet und/oder angeordnet ist, dass sich eine Kapazitätskenngröße des Sensorelements (22) in Abhängigkeit von einer Kontaktierung der Oberfläche (14) mittels eines Objekts ändert, und mit zumindest einer Auswerteeinheit (26), die dazu eingerichtet ist, in Abhängigkeit von einem differentiellen Signal des Sensorelements (22) Regentropfen auf der Oberfläche (14) zu erkennen, **dadurch gekennzeichnet, dass** die Auswerteeinheit (26) dazu eingerichtet ist, in Abhängigkeit von einer Symmetriekenngröße des differentiellen Signals, insbesondere gegenüber einem Nullpunkt, einen Regentropfen auf der Oberfläche (14) zu erkennen, wobei die Symmetriekenngröße eine Symmetrie einer Signalform und/oder über einen Signalverlauf getrennter Wertemengen des differentiellen Signals beschreibt und wobei das differentielle Signal als ein zeitlicher Verlauf einer Änderungsrate der Kapazitätskenngröße des Sensorelements definiert ist.

2. Regenerkennungsvorrichtung nach Anspruch 1, **dadurch gekennzeichnet, dass** die Symmetriekenngröße als ein Verhältnis einer positiven Gewichtungskenngröße des differentiellen Signals und einer negativen Gewichtungskenngröße des differentiellen Signals ausgebildet ist, wobei die Auswerteeinheit (26) dazu eingerichtet ist, in Abhängigkeit von einer Überschreitung eines Grenzwerts oder eines Grenzbereichs der Symmetriekenngröße einen Regentropfen auf der Oberfläche (14) zu erkennen, insbesondere wobei die Gewichtungskenngröße als Kenngröße definiert ist, die einen zeitlichen Verlauf des Signals anhand einer spezifischen Gewichtung relativ zu einem Bezugspunkt, insbesondere einem Nullpunkt, beschreibt und/oder angibt.

3. Regenerkennungsvorrichtung nach Anspruch 1 oder 2, **dadurch gekennzeichnet, dass** die Auswerteeinheit (26) dazu eingerichtet ist, das differentielle Signal in Zeitintervallen, insbesondere kontinuierlich, stückweise auszuwerten und für jedes ausgewertete Zeitintervall genau einen booleschen Wert eines Regenzustands an der Oberfläche (14) auszugeben.

4. Regenerkennungsvorrichtung nach einem der vorhergehenden Ansprüche, **dadurch gekennzeichnet, dass** die Auswerteeinheit (26) dazu eingerichtet ist, in Abhängigkeit von der Erkennung von Regentropfen auf der Oberfläche (14) zumindest ein Ausgabesignal, insbesondere einen booleschen Wert eines Regenzustands an der Oberfläche (14), auszugeben, wobei die Auswerteeinheit (26) dazu eingerichtet ist, eine Ausgabe des Ausgabesignals und/oder eine Änderung des Ausgabesignals zeitlich zu limitieren.

5. Regenerkennungsvorrichtung nach einem der vorhergehenden Ansprüche, **dadurch gekennzeichnet, dass** das kapazitive Sensorelement (22) zumindest ein, insbesondere genau ein, Elektrodenpaar (24) ausbildet, welches zumindest elektrisch mit der Auswerteeinheit (26) verbunden ist, wobei das Elektrodenpaar (24) eine maximale Erfassungsfläche (56) aufspannt, die mindestens 12 cm² beträgt.

6. Regenerkennungsvorrichtung nach einem der vorhergehenden Ansprüche, **dadurch gekennzeichnet, dass** die Sensoreinheit (16) zumindest teilweise als eine, insbesondere zumindest im Wesentlichen biegeschlaffe, flexible Membran ausgebildet ist, welche zumindest elektrisch mit der Auswerteeinheit (26) verbunden ist.

7. Gartengerät, insbesondere Rasenmäher, mit zumindest einer Regenerkennungsvorrichtung (12) nach einem der vorhergehenden Ansprüche.

8. Verfahren zu einer Erfassung von Regentropfen auf einer Oberfläche (14) mittels einer Regenerkennungsvorrichtung (12), insbesondere einer Regenerkennungsvorrichtung (12) nach einem der Ansprüche 1 bis 6, wobei in zumindest einem Verfahrensschritt (102) mittels eines kapazitiven Sensorelements (22) der Regenerkennungsvorrichtung (12) eine Kapazitätskenngröße erfasst wird, wobei in zumindest einem Verfahrensschritt (108) -mittels einer Auswerteeinheit (26) der Regenerkennungsvorrichtung (12) in Abhängigkeit von einem differentiellen Signal des Sensorelements (22) eine Erkennung von Regentropfen auf der Oberfläche (14) erfolgt, **dadurch gekennzeichnet, dass** in zumindest einem Verfahrensschritt (108) die Erkennung von Regentropfen auf der Oberfläche (14) mittels der Auswerteeinheit (26) in Abhängigkeit von einer Symmetriekenngröße des differentiellen Signals, insbesondere gegenüber einem Nullpunkt, erfolgt, wobei die Symmetriekenngröße eine Symmetrie einer Signalform und/oder über einen Signalverlauf getrennter Wertemengen des differentiellen Signals beschreibt und wobei das differentielle Signal als ein zeitlicher Verlauf einer Änderungsrate der Kapazitätskenngröße des Sensorelements definiert ist.

9. Verfahren nach Anspruch 8, **dadurch gekennzeichnet, dass** in zumindest einem Verfahrensschritt (108) das kontinuierliche differentielle Signal mittels der Auswerteeinheit (26) zur Erkennung von Regentropfen auf der Oberfläche (14) in Abhängigkeit von zumindest einer Gewichtungskenngröße des differentiellen Signals über ein vorgegebenes oder ein dynamisches Zeitintervall ausgewertet wird.

10. Verfahren nach einem der Ansprüche 8 oder 9, **dadurch gekennzeichnet, dass** in zumindest einem Verfahrensschritt (106), insbesondere vor einer Auswertung zur Erkennung von Regentropfen auf der Oberfläche (14), das differentielle Signal mittels der Auswerteeinheit (26) nach Störsignalen gefiltert wird.

11. Verfahren nach einem der Ansprüche 8 bis 10, **dadurch gekennzeichnet, dass** in zumindest einem Verfahrensschritt (112) mittels einer Steuer- und/oder Regeleinheit (34) der Regenerkennungsvorrichtung (12) zumindest ein Auswertungsparameter der Auswerteeinheit (26) in Abhängigkeit von einer, insbesondere über die Auswerteeinheit (26), automatisch ermittelten und/oder vorgegebenen Sensitivitätskenngröße angepasst wird.

## Claims

1. Rain detection device for sensing rain drops on a surface (14), having at least one sensor unit (16) comprising at least one capacitive sensor element (22), the sensor element (22) being designed and/or arranged in such a way that a capacitance characteristic value of the sensor element (22) changes depending on an object contacting the surface (14), and having at least one evaluation unit (26) which is configured to detect rain drops on the surface (14) depending on a differential signal from the sensor element (22), **characterized in that** the evaluation unit (26) is configured to detect a rain drop on the surface (14) depending on a symmetry characteristic value of the differential signal, in particular with respect to a zero point, wherein the symmetry characteristic value describes a symmetry of a signal shape and/or of separate value sets of the differential signal across a waveform and wherein the differential signal is defined as a temporal waveform of a rate of change of the capacitance characteristic value of the sensor element.

2. Rain detection device according to Claim 1, **characterized in that** the symmetry characteristic value is formed as a ratio of a positive weighting characteristic value of the differential signal and a negative weighting characteristic value of the differential signal, the evaluation unit (26) being configured to detect a rain drop on the surface (14) depending on a limit value or a limit range of the symmetry characteristic value being exceeded, in particular wherein the weighting characteristic value is defined as a characteristic value which describes and/or indicates a temporal waveform of the signal based on a specific weighting relative to a reference point, in particular a zero point.

3. Rain detection device according to Claim 1 or 2, **characterized in that** the evaluation unit (26) is configured to evaluate the differential signal piecewise at time intervals, in particular continuously, and to output exactly one Boolean value of a rain condition on the surface (14) for each time interval evaluated.

4. Rain detection device according to any one of the preceding claims, **characterized in that** the evaluation unit (26) is configured to output at least one output signal, in particular a Boolean value of a rain condition on the surface (14), depending on the detection of rain drops on the surface (14), the evaluation unit (26) being configured to temporally limit an output of the output signal and/or a change in the output signal.

5. Rain detection device according to any one of the preceding claims, **characterized in that** the capacitive sensor element (22) forms at least one, in particular exactly one, electrode pair (24) which is at least electrically connected to the evaluation unit (26), the electrode pair (24) covering a maximum sensing area (56) of at least 12 cm².

6. Rain detection device according to any one of the preceding claims, **characterized in that** the sensor unit (16) is designed at least partially as an in particular at least essentially non-rigid, flexible membrane which is at least electrically connected to the evaluation unit (26).

7. Garden appliance, in particular lawnmower, having at least one rain detection device (12) according to any one of the preceding claims.

8. Method for sensing rain drops on a surface (14) by means of a rain detection device (12), in particular a rain detection device (12) according to any one of Claims 1 to 6, wherein, in at least one method step (102), a capacitive sensor element (22) of the rain detection device (12) is used to sense a capacitance characteristic value, wherein, in at least one method step (108), rain drops are detected on the surface (14) depending on a differential signal of the sensor element (22) by means of an evaluation unit (26) of the rain detection device (12), **characterized in that**, in at least one method step (108), raindrops on the surface (14) are detected by means of the evaluation unit (26) depending on a symmetry characteristic value of the differential signal, in particular with respect to a zero point, wherein the symmetry characteristic value describes a symmetry of a signal shape and/or of separate value sets of the differential signal across a waveform and wherein the differential signal is defined as a temporal waveform of a rate of change of the capacitance characteristic value of the sensor element.

9. Method according to Claim 8, **characterized in that**, in at least one method step (108), the continuous differential signal is evaluated by means of the evaluation unit (26) to detect rain drops on the surface (14) depending on at least one weighting characteristic value of the differential signal over a predefined or a dynamic time interval.

10. Method according to either one of Claims 8 and 9, **characterized in that**, in at least one method step (106), in particular before an evaluation for detecting rain drops on the surface (14), the differential signal is filtered for interference signals by means of the evaluation unit (26).

11. Method according to any one of Claims 8 to 10, **characterized in that**, in at least one method step (112), by means of a control and/or regulation unit (34) of the rain detection device (12), at least one evaluation parameter of the evaluation unit (26) is adjusted depending on a sensitivity characteristic value automatically determined and/or predefined, in particular via the evaluation unit (26).

## Revendications

1. Dispositif de détection de pluie servant à détecter des gouttes de pluie sur une surface (14), comprenant au moins une unité de détection (16) qui présente au moins un élément capteur (22) capacitif, l'élément capteur (22) étant conçu et/ou disposé de telle sorte qu'une caractéristique de capacité de l'élément capteur (22) varie en fonction du contact d'un objet avec la surface (14), et comprenant au moins une unité d'évaluation (26) qui est conçue pour détecter des gouttes de pluie sur la surface (14) en fonction d'un signal différentiel de l'élément capteur (22), **caractérisé en ce que** l'unité d'évaluation (26) est conçue pour détecter une goutte de pluie sur la surface (14) en fonction d'une caractéristique de symétrie du signal différentiel, en particulier par rapport à un point zéro, la caractéristique de symétrie décrivant une symétrie d'une forme de signal et/ou, par l'intermédiaire d'une courbe d'évolution du signal, des ensembles de valeurs séparés du signal différentiel, et le signal différentiel étant défini sous la forme d'une courbe d'évolution dans le temps d'un taux de variation de la caractéristique de capacité de l'élément capteur.

2. Dispositif de détection de pluie selon la revendication 1, **caractérisé en ce que** la caractéristique de symétrie est conçue sous la forme d'un rapport entre une caractéristique de pondération positive du signal différentiel et une caractéristique de pondération négative du signal différentiel, l'unité d'évaluation (26) étant conçue pour détecter une goutte de pluie sur la surface (14) en fonction d'un dépassement d'une valeur limite ou d'une plage limite de la caractéristique de symétrie, en particulier, la caractéristique de pondération étant définie sous la forme d'une caractéristique qui décrit et/ou spécifie une courbe d'évolution dans le temps du signal sur la base d'une pondération spécifique par rapport à un point de référence, en particulier un point zéro.

3. Dispositif de détection de pluie selon la revendication 1 ou 2, **caractérisé en ce que** l'unité d'évaluation (26) est conçue pour évaluer le signal différentiel par morceaux dans des intervalles de temps, en particulier en continu, et pour chaque intervalle de temps évalué, pour délivrer exactement une valeur booléenne d'un état de pluie sur la surface (14).

4. Dispositif de détection de pluie selon l'une quelconque des revendications précédentes, **caractérisé en ce que** l'unité d'évaluation (26) est conçue pour fournir en sortie au moins un signal de sortie, en particulier une valeur booléenne d'un état de pluie sur la surface (14), en fonction de la détection de gouttes de pluie sur la surface (14), l'unité d'évaluation (26) étant conçue pour limiter dans le temps la fourniture en sortie du signal de sortie et/ou une variation du signal de sortie.

5. Dispositif de détection de pluie selon l'une quelconque des revendications précédentes, **caractérisé en ce que** l'élément capteur capacitif (22) est formé d'au moins une paire d'électrodes (24), en particulier exactement une, qui est reliée au moins électriquement à l'unité d'évaluation (26), la paire d'électrodes (24) couvrant une surface de détection maximale (56) qui est d'au moins 12 cm².

6. Dispositif de détection de pluie selon l'une quelconque des revendications précédentes, **caractérisé en ce que** l'unité de détection (16) est au moins partiellement conçue sous la forme d'une membrane flexible, en particulier au moins sensiblement souple, qui est reliée au moins électriquement à l'unité d'évaluation (26).

7. Appareil de jardinage, en particulier tondeuse à gazon, doté d'au moins un dispositif de détection de pluie (12) selon l'une quelconque des revendications précédentes.

8. Procédé de détection de gouttes de pluie sur une surface (14) au moyen d'un dispositif de détection de pluie (12), en particulier d'un dispositif de détection de pluie (12) selon l'une quelconque des revendications 1 à 6, une caractéristique de capacité étant détectée, au cours d'au moins une étape de procédé (102), au moyen d'un élément capteur capacitif (22) du dispositif de détection de pluie (12), une détection de gouttes de pluie sur la surface (14) étant effectuée, au cours d'au moins une étape de procédé (108), au moyen d'une unité d'évaluation (26) du dispositif de détection de pluie (12) en fonction d'un signal différentiel de l'élément capteur (22), **caractérisé en ce que**, au cours d'au moins une étape de procédé (108), la détection de gouttes de pluie sur la surface (14) est effectuée au moyen de l'unité d'évaluation (26) en fonction d'une caractéristique de symétrie du signal différentiel, en particulier par rapport à un point zéro, la caractéristique de symétrie décrivant une symétrie d'une forme de signal et/ou, par l'intermédiaire d'une courbe d'évolution du signal, des ensembles de valeurs séparés du signal différentiel, et le signal différentiel étant défini sous la forme d'une courbe d'évolution dans le temps d'un taux de variation de la caractéristique de capacité de l'élément capteur.

9. Procédé selon la revendication 8, **caractérisé en ce que**, au cours d'au moins une étape de procédé (108), le signal différentiel continu est évalué au moyen de l'unité d'évaluation (26) pour détecter des gouttes de pluie sur la surface (14) en fonction d'au moins une caractéristique de pondération du signal différentiel pendant un intervalle de temps prédéfini ou dynamique.

10. Procédé selon l'une quelconque des revendications 8 ou 9, **caractérisé en ce que**, au cours d'au moins une étape de procédé (106), en particulier avant une évaluation servant à détecter des gouttes de pluie sur la surface (14), le signal différentiel est filtré au moyen de l'unité d'évaluation (26) pour détecter des signaux parasites.

11. Procédé selon l'une quelconque des revendications 8 à 10, **caractérisé en ce que**, au cours d'au moins une étape de procédé (112), au moins un paramètre d'évaluation de l'unité d'évaluation (26) est adapté, au moyen d'une unité de commande et/ou de régulation (34) du dispositif de détection de pluie (12), en fonction d'une caractéristique de sensibilité déterminée et/ou prédéfinie automatiquement, en particulier par l'intermédiaire de l'unité d'évaluation (26).
